# EUROPEAN PATENT APPLICATION

(11) **EP 2 541 641 A1**
(43) Date of publication of application: **02.01.2013**
(21) Application number: 11747061.7
(22) Date of filing: 24.02.2011
(51) Int. Cl.: H01M 2/10, H01M 2/20, H01M 2/30, H01M 2/34, H01M 10/48

(54) **BATTERY MODULE, BATTERY SYSTEM, ELECTRIC VEHICLE, MOBILE BODY, POWER STORAGE DEVICE, POWER SUPPLY DEVICE, AND ELECTRIC APPARATUS**

(30) Priority: 24.02.2010 JP 2010039368
(71) Applicant: Sanyo Electric Co., Ltd., Osaka 570-8677 (JP)
(72) Inventor: OHKURA, Kazumi, Moriguchi-City Osaka 570-8677 (JP); NISHIHARA, Yoshitomo, Moriguchi-City Osaka 570-8677 (JP); MIYAZAKI, Yutaka, Moriguchi-City Osaka 570-8677 (JP); ASAI, Yasuhiro, Moriguchi-City Osaka 570-8677 (JP)
(74) Representative: Glawe, Delfs, Moll
(86) International application number: PCT/JP2011/001082
(87) International publication number: WO 2011/105095

(57) **Abstract**

A battery module includes a battery block and a printed circuit board. The battery block includes a plurality of laminated battery cells. A detection circuit and an amplification circuit are mounted on the printed circuit board. In the battery block, a bus bar is attached to electrodes of the two battery cells in close proximity to each other so that the plurality of battery cells are connected in series. The bus bar attached to one of the electrodes of the battery cell at one end of the battery block is used as a shunt resistor for current detection. The detection circuit detects a voltage between both ends of the shunt resistor, which has been amplified by the amplification circuit.

## Description

### [Technical Field]

The present invention relates to a battery module, and a battery system, an electric vehicle, a movable body, a power storage device, a power supply device, and electrical equipment including the same.

### [Background Art]

Driving sources of movable bodies such as an electric automobile, battery modules capable of charge and discharge are used. Such a battery module has a configuration in which a plurality of batteries (battery cells) are connected in series, for example.

A user of the movable body including the battery module needs to grasp a remaining amount of the battery capacity (a charged capacity) of the battery module. When the battery module is charged and discharged, each of the batteries constituting the battery module needs to be prevented from being overcharged and overdischarged. Therefore, a device that monitors a state of the battery module has been discussed (see, e.g., Patent Document 1).
[Patent Document 1] JP 8-162171 A

### [Summary of Invention]

### [Technical Problem]

When the state of the battery module is monitored, as described above, however, not only a voltage between both terminals but a current flowing through the battery module is preferably monitored. More specific control of an assembled battery can be performed by monitoring more information as a state of each battery module. However, in a monitoring device of an assembled battery discussed in Patent Document 1, a current flowing through a battery module cannot be detected. When the monitoring device is provided with a current detection device, the monitoring device is increased in size and complicated.

An object of the present invention is to provide a battery module capable of detecting a current flowing through a plurality of battery cells in a simple configuration, and a battery system and an electric vehicle including the same.

### [Solution to Problem]

(1) According to one aspect of the present invention, a battery module includes a battery block including a plurality of battery cells, and a shunt resistor for current detection attached to one of electrodes of the battery cell at one end of the battery block.

In the battery module, the shunt resistor for current detection is attached to one of the electrodes of the battery cell at the one end of the battery block. In this case, the shape and the dimensions of the shunt resistor are not limited by a spacing between the adjacent battery cells. Thus, the shunt resistor can be easily set to its optimum value. As a result, a current flowing through the battery module can be detected in a simple configuration.

(2) The battery block may have a first output terminal that outputs electric power from each of the plurality of battery cells, and the shunt resistor may be connected between the one electrode of the battery cell at the one end and the first output terminal.

In this case, the battery block need not be provided with an additional terminal for connecting the shunt resistor. Thus, the battery module can be provided with a second connection member without increasing a manufacturing process and a manufacturing cost.

(3) The battery module may further include a first connection member that connects the respective electrodes of the plurality of battery cells to one another, and a second connection member that connects the one electrode of the battery cell at the one end and the first output terminal to each other, in which at least a part of the second connection member may be used as the shunt resistor.

In this case, the first and second connection members electrically connect the plurality of battery cells while the second connection member also functions as the shunt resistor. Therefore, the battery module need not be separately provided with the shunt resistor. As a result, the current flowing through the battery module can be detected without increasing the battery module in size.

(4) The battery block may further have a second output terminal that outputs electric power from each of the plurality of battery cells, and the battery module may further include a third connection member that connects one of the electrodes of the battery cell at the other end of the battery block and the second output terminal to each other.

In this case, to take out the electric power from the battery block, a connection line can be easily connected to the second output terminal without being directly connected to one of the electrodes of the battery cell at the other end.

(5) Each of the battery cells may include a first electrode formed of a first metal material, and a second electrode formed of a second metal material, the first connection member may include a first portion formed of a third metal material, and a second portion formed of a fourth metal material, the first portion in the first connection member may be connected to the first electrode of the one battery cell, the second portion in the first connection member may be connected to the second electrode of the other battery cell, one of the electrodes of the battery cell at the one end may be the first electrode, one of the electrodes of the battery cell at the other end may be the second electrode, the second connection member may be formed of a fifth metal material, and may be attached to one of the electrodes of the battery cell at the one end, the third connection member may include a sixth metal material formed of a first metal, and a second portion formed of a seventh metal material, the first portion in the third connection member may be connected to the second output terminal, and the second portion in the third connection member may be connected to the one electrode of the battery cell at the other end, and the first, third, fifth, and sixth metal materials may include copper, and the second, fourth, and seventh metal materials may include aluminum.

In this case, the metal materials forming the first electrode of each of the battery cells, the one electrode of the battery cell at the one end, the first portion in the first connection member, the second connection member, and the first portion in the third connection member include copper, and the metal materials forming the second electrode of each of the battery cells, the one electrode of the battery cell at the other end, the second portion in the first connection member, and the second portion in the third connection member include aluminum.

Therefore, no bimetallic corrosion occurs between the first portion in the first connection member and the first electrode of the one battery cell, between the second portion in the first connection member and the second electrode of the other battery cell, between the second connection member and the one electrode of the battery cell at the one end, and between the second portion in the third connection member and the one electrode of the battery cell at the other end. As a result, the durability and the reliability of the battery module are improved.

(6) The battery module may further include a voltage detector that detects a voltage between both ends of the shunt resistor in the second connection member. In this case, the voltage detector detects the voltage between both ends of the shunt resistor. Thus, the current flowing through the battery module can be easily calculated based on the voltage between both ends of the shunt resistor.

(7) The battery module may further include a wiring substrate having first and second conductor patterns electrically connected to the voltage detector, the second connection member may be a metal plate attached to the one electrode of the battery cell at the one end, the metal plate may include a first region corresponding to one end of the shunt resistor, and a second region corresponding to the other end of the shunt resistor, and the first and second regions in the metal plate may be respectively joined to the first and second conductor patterns of the wiring substrate.

In this case, the first region in the metal plate corresponding to the one end of the shunt resistor is electrically connected to the voltage detector via the first conductor pattern of the wiring substrate while the second region in the metal plate corresponding to the other end of the shunt resistor is electrically connected to the voltage detector via the second conductor pattern of the wiring substrate. Thus, a current flowing through the plurality of battery cells can be detected in a simpler configuration.

(8) At least one of the second and third connection members and the first connection member may be arranged along one direction, and the wiring substrate may be provided to extend along at least one of the second and third connection members and the first connection member. In this case, at least one of the second and third connection members and the first connection member are arranged along one direction so that at least one of the second and third connection members and the first connection member can be easily connected to the wiring substrate.

(9) According to another aspect of the present invention, a battery system includes the battery module according to the one aspect of the present invention, and a current calculator that calculates a current flowing through the shunt resistor in the battery module.

In the battery system, the current calculator calculates the current flowing through the shunt resistor based on a voltage between both ends of the shunt resistor.

In the battery module, a shunt resistor for current detection is attached to one of the electrodes of the battery cell at the one end of the battery block. In this case, the shape and the dimensions of the shunt resistor are not limited by a spacing between the adjacent battery cells. Thus, the shunt resistor can be easily set to its optimum value. As a result, a current flowing through the battery module can be detected in a simple configuration.

(10) According to still another aspect of the present invention, an electric vehicle includes the battery module according to the one aspect of the present invention, a motor that is driven with electric power from the battery module, and a drive wheel that rotates with a torque generated by the motor.

In the electric vehicle, the motor is driven with the electric power from the battery module. The drive wheel rotates with the torque generated by the motor so that the electric vehicle moves.

In the battery module, a shunt resistor for current detection is attached to one of the electrodes of the battery cell at the one end of the battery block. In this case, the shape and the dimensions of the shunt resistor are not limited by a spacing between the adjacent battery cells. Thus, the shunt resistor can be easily set to its optimum value. As a result, a current flowing through the battery module can be detected in a simple configuration while the electric vehicle can be controlled based on a value of the current flowing through the battery module.

(11) According to yet still another aspect of the present invention, a movable body includes one or a plurality of battery modules each including a plurality of battery cells, a main movable body, and a power source that converts electric power from each of the one or plurality of battery modules into power for moving the main movable body, in which at least one of the one or plurality of battery modules is the battery module according to the one aspect of the present invention.

In the movable body, the power source converts the electric power from each of the one or plurality of battery modules into the power, and the main movable body moves with the power. In this case, at least one of the one or plurality of battery modules is the above-mentioned battery module according to the present invention so that a current flowing through the one or plurality of battery modules can be detected in a simple configuration.

(12) According to a further aspect of the present invention, a power storage device includes one or a plurality of battery modules each including a plurality of battery cells, and a controller that performs control relating to discharge or charge of each of the one or plurality of battery modules, in which at least one of the one or plurality of battery modules is the battery module according to the one aspect of the present invention.

In the power storage device, the controller performs control relating to discharge or charge of each of the one or plurality of battery modules.

For example, when the one or plurality of battery modules are discharged, the controller determines whether the discharge of each of the one or plurality of battery modules is stopped or not or whether a discharging current (or discharging electric power) is limited or not based on the charged capacity of the battery cell, and controls the power conversion device based on a determination result. More specifically, when the charged capacity of any one of the plurality of battery cells becomes smaller than a predetermined threshold value, the controller controls the power conversion device so that the discharge of the one or plurality of battery modules is stopped or the discharging current (or discharging electric power) is limited.

The controller can also determine whether the discharge of the one or plurality of battery modules is stopped or not or whether the discharging current (or discharging electric power) is limited or not based on an instruction from an external object, and control the power conversion device based on a determination result.

On the other hand, when the one or plurality of battery modules are charged, the controller determines whether the charge of the one or plurality of battery modules is stopped or not or whether a charging current (or charging electric power) is limited or not based on the charged capacity of the battery cell, and controls the power conversion device based on a determination result. More specifically, when the charged capacity of any one of the plurality of battery cells included in each of the one or plurality of battery modules becomes larger than a predetermined threshold value, the controller controls the power conversion device so that the charge of the one or plurality of battery modules is stopped or the charging current (or charging electric power) is limited.

The controller can also determine whether the charge of the one or plurality of battery modules is stopped or not or whether the charging current (or charging electric power) is limited or not based on an instruction from an external object, and control the power conversion device based on an instruction from a determination result.

Thus, the one or plurality of battery modules can be prevented from being overdischarged and overcharged.

In this case, the one or plurality of battery modules are the above-mentioned battery module according to the present invention so that the current flowing through the battery module can be detected in a simple configuration.

(13) According to a still further aspect of the present invention, a power supply device connectable to an external object includes the power storage device according to the further aspect, and a power conversion device that converts electric power between each of the one or plurality of battery modules in the power storage device and the external object, in which the controller controls the power conversion device.

In the power supply device, the power conversion device converts the electric power between each of the one or plurality of battery modules and the external object.

For example, when the one or plurality of battery modules are discharged, the controller determines whether the discharge of the one or plurality of battery modules is stopped or not or whether a discharging current (or discharging electric power) is limited or not based on the charged capacity of the battery cell, and controls the power conversion device based on a determination result. More specifically, when the charged capacity of any one of the plurality of battery cells becomes smaller than a predetermined threshold value, the controller controls the power conversion device so that the discharge of the one or plurality of battery modules is stopped or the discharging current (or discharging electric power) is limited.

The controller can also determine whether the discharge of the one or plurality of battery modules is stopped or not or whether the discharging current (or discharging electric power) is limited or not based on an instruction from the external object, and control the power conversion device based on a determination result.

On the other hand, when the one or plurality of battery modules are charged, the controller determines whether the charge of the one or plurality of battery modules is stopped or not or whether a charging current (or charging electric power) is limited or not based on the charged capacity of the battery cell, and controls the power conversion device based on a determination result. More specifically, when the charged capacity of any one of the plurality of battery cells included in each of the one or plurality of battery modules becomes larger than a predetermined threshold value, the controller controls the power conversion device so that the charge of the one or plurality of battery modules is stopped or the charging current (or charging electric power) is limited.

The controller can also determine whether the charge of the one or plurality of battery modules is stopped or not or whether the charging current (or charging electric power) is limited or not based on an instruction from the external object, and control the power conversion device based on a determination result.

Thus, the plurality of battery modules can be prevented from being overdischarged and overcharged.

In this case, the one or plurality of battery modules are the above-mentioned battery module according to the present invention so that the current flowing through the battery module can be detected in a simple configuration.

(14) According to a yet further aspect of the present invention, electrical equipment includes one or a plurality of battery modules each including a plurality of battery cells, and a load driven with electric power from the one or plurality of battery modules, in which at least one of the one or plurality of battery modules is the battery module according to the one aspect of the present invention.

In the electrical equipment, the load is driven with the electric power from the one or plurality of battery modules. In this case, the one or plurality of battery modules are the above-mentioned battery module according to the present invention so that the current flowing through the battery module can be detected in a simple configuration.

### [Advantageous Effects of Invention]

According to the present invention, a current flowing through a battery module can be detected in a simple configuration.

### [Brief Description of Drawings]

[FIG. 1] FIG. 1 is a block diagram illustrating a configuration of a battery system according to a first embodiment.
[FIG. 2] FIG. 2 is an external perspective view of a battery module.
[FIG. 3] FIG. 3 is a plan view of the battery module.
[FIG. 4] FIG. 4 is a side view of the battery module.
[FIG. 5] FIG. 5 is a plan view of a voltage bus bar.
[FIG. 6] FIG. 6 is a plan view of a voltage/current bus bar.
[FIG. 7] FIG. 7 is an external perspective view illustrating a state where a plurality of voltage bus bars and a voltage/current bus bar are attached to an FPC board.
[FIG. 8] FIG. 8 is an external perspective view at one end of the battery module.
[FIG. 9] FIG. 9 is an external perspective view at the other end of the battery module.
[FIG. 10] FIG. 10 is a side view of a battery block.
[FIG. 11] FIG. 11 is a schematic plan view for illustrating connection of a plurality of voltage bus bars and a voltage/current bus bar with a detection circuit.
[FIG. 12] FIG. 12 is a schematic plan view for illustrating connection of a plurality of voltage bus bars and a voltage/current bus bar with a detection circuit.
[FIG. 13] FIG. 13 is a circuit diagram illustrating an example of one configuration of a detection circuit illustrated in Fig. 1.
[FIG. 14] FIG. 14 is a circuit diagram illustrating an example of one configuration of an amplification circuit illustrated in Fig. 13.
[FIG. 15] FIG. 15 is a circuit diagram illustrating another example of a configuration of a detection circuit illustrated in Fig. 1.
[FIG. 16] FIG. 16 is a plan view of a voltage/current bus bar in another example.
[FIG. 17] FIG. 17 is a diagram illustrating an example of a configuration of a detection circuit having a current calculation function.
[FIG. 18] FIG. 18 is a schematic plan view illustrating a configuration of a voltage/current bus bar and its peripheral members according to a modified example.
[FIG. 19] FIG. 19 is a block diagram illustrating a configuration of an electric automobile including the battery system illustrated in Fig. 1.
[FIG. 20] FIG. 20 is a block diagram illustrating a configuration of a power supply device according to a third embodiment.
[FIG. 21] FIG. 21 is a schematic plan view illustrating a configuration of a battery system in a power supply device.
[FIG. 22] FIG. 22 is a perspective view of a rack that houses a plurality of battery systems.
[FIG. 23] FIG. 23 is a schematic plan view illustrating a state where the battery system illustrated in Fig. 21 is housed in a housing space in the rack illustrated in Fig. 22.
[FIG. 24] FIG. 24 is a plan view illustrating another example of a battery module in the battery system.
[FIG. 25] FIG. 25 is a plan view illustrating still another example of a battery module in the battery system.
[FIG. 26] FIG. 26 is a schematic plan view illustrating another configuration of the power supply device.
[FIG. 27] FIG. 27 is a schematic plan view illustrating a configuration of a battery system in another configuration of the power supply device.
[FIG. 28] FIG. 28 is a side view illustrating another configuration of a battery block.
[FIG. 29] FIG. 29 is an external perspective view illustrating a state where a plurality of voltage bus bars and a voltage/current bus bar are attached to FPC boards.
[FIG. 30] FIG. 30 is an external perspective view illustrating another example of wiring members.

### [Description of Embodiments]

### [1] First Embodiment

A battery module according to a first embodiment and a battery system including the same will be described with reference to the drawings. The battery module and the battery system according to the present embodiment are mounted on an electric vehicle (e.g., an electric automobile) using electric power as a driving source.

### (1) Configuration of Battery System

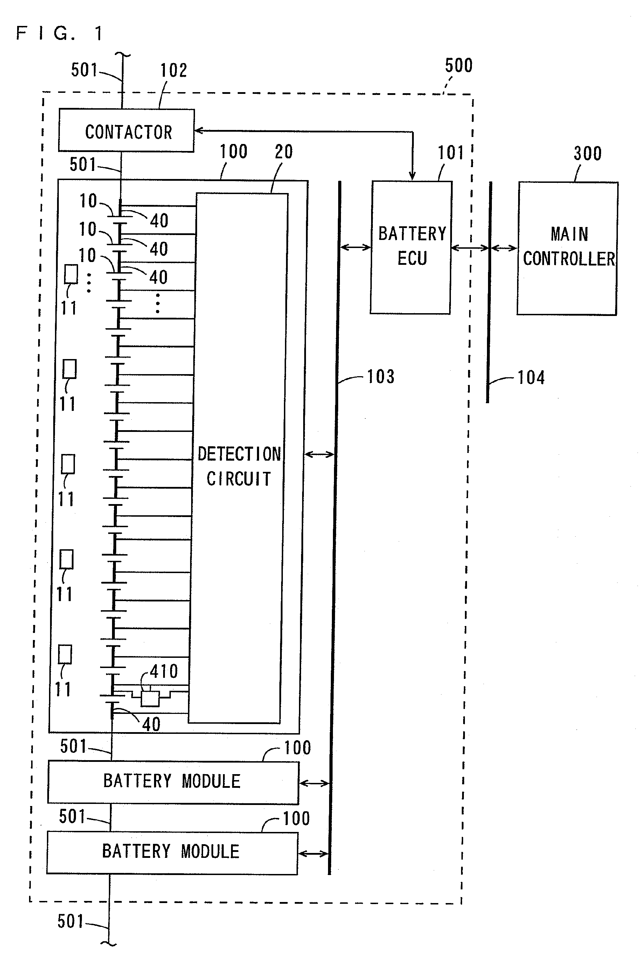

Fig. 1 is a block diagram illustrating a configuration of a battery system according to a first present embodiment. As illustrated in Fig. 1, a battery system 500 includes a plurality of battery modules 100, a battery ECU (Electronic Control Unit) 101, and a contactor 102, and is connected to a main controller 300 in an electric vehicle via a bus 104.

The plurality of battery modules 100 in the battery system 500 are connected to one another via a power supply line 501. Each of the battery modules 100 includes a plurality of (eighteen in this example) battery cells 10, a plurality of (five in this example) thermistors 11, and a detection circuit 20.

In each of the battery modules 100, the plurality of battery cells 10 are integrally arranged to be adjacent to one another, and are connected in series via the plurality of bus bars 40. Each of the battery cells 10 is a secondary battery such as a lithium-ion battery or a nickel hydride battery.

The battery cells 10 arranged at both ends are respectively connected to the power supply line 501 via bus bars 40. Thus, all the battery cells 10 in the plurality of battery modules 100 are connected in series in the battery system 500. The power supply line 501, which is pulled out of the battery system 500, is connected to a load such as a motor of the electric vehicle.

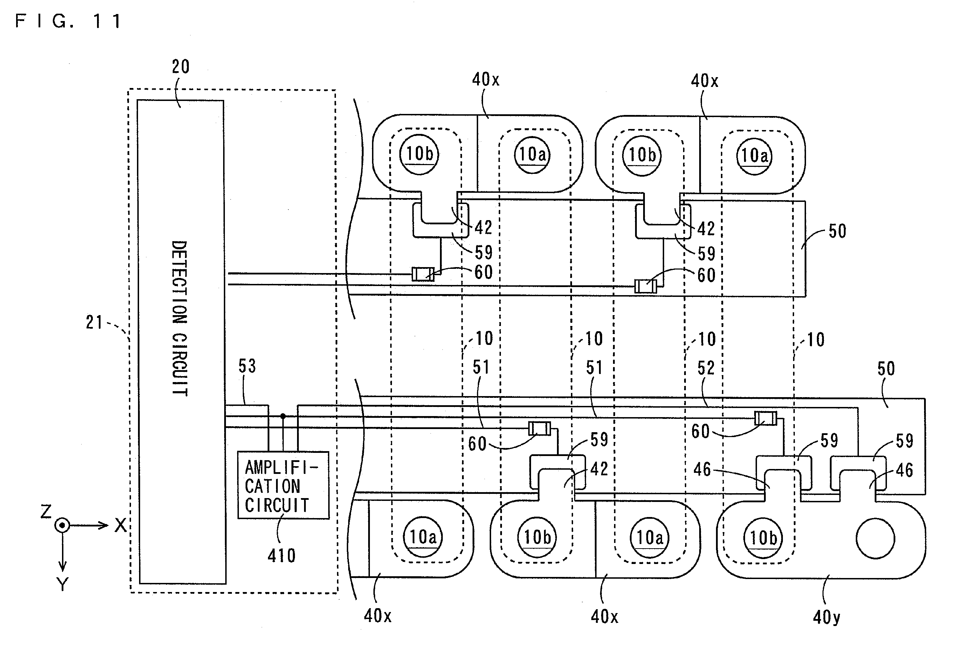

The detection circuit 20 is connected to each of the bus bars 40 via a conductor line 51 (see Fig. 11, described below). The detection circuit 20 is electrically connected to each of the thermistors 11. The detection circuit 20 detects a voltage between terminals (a battery voltage) and a temperature of each of the battery cells 10.

The detection circuit 20 in each of the battery modules 100 is connected to the battery ECU 101 via a bus 103. Thus, the voltage and the temperature, which have been detected by the detection circuit 20, are given to the battery ECU 101.

Further, in the present embodiment, between the bus bar 40 of the battery cell 10 at the one end and the detection circuit 20, an amplification circuit 410 for amplifying an amount of voltage drop by a current flowing through each bus bar 40 is provided. The detection circuit 20 gives a voltage value based on an output voltage of the amplification circuit 410 to the battery ECU 101. Thus, the battery ECU 101 calculates a value of a current flowing through the battery module 100. Details of the bus bar 40 and the amplification circuit 410 and details of calculation of the current value by the detection circuit 20 and the battery ECU 101 will be described below.

The battery ECU 101 calculates a charged capacity of each of the battery cells 10 based on a voltage and a temperature, which have been given from the detection circuit 20 and the detected current, for example, and controls charge and discharge of each battery module 100 based on the charged capacity. The battery ECU 101 detects a state of each of the battery modules 100, for example, the life of the battery cell 10 and an abnormality based on the given voltage and temperature and the detected current. The abnormality in the battery module 100 includes overdischarge, overcharge, or an abnormal temperature of the battery cell 10.

The contactor 102 is inserted into the power supply line 501 connected to the battery module 100 at the one end. The battery ECU 101 turns off, when it has detected the abnormality in the battery module 100, the contactor 102. Since no current flows through each of the battery modules 100 when the abnormality occurs therein, the battery module 100 is prevented from being abnormally heated.

The battery ECU 101 is connected to the main controller 300 in the electric vehicle via the bus 104. The charged capacity of each of the battery modules 100 (the charged capacities of each of the battery cells 10) is given from the battery ECU 101 to the main controller 300. The main controller 300 controls power of the electric vehicle (e.g., a rotational speed of the motor) based on the charged capacity. When the charged capacity of each of the battery modules 100 is reduced, the main controller 300 controls a power generation device (not illustrated) connected to the power supply line 501, to charge the battery module 100.

### (2) Details of Battery Module

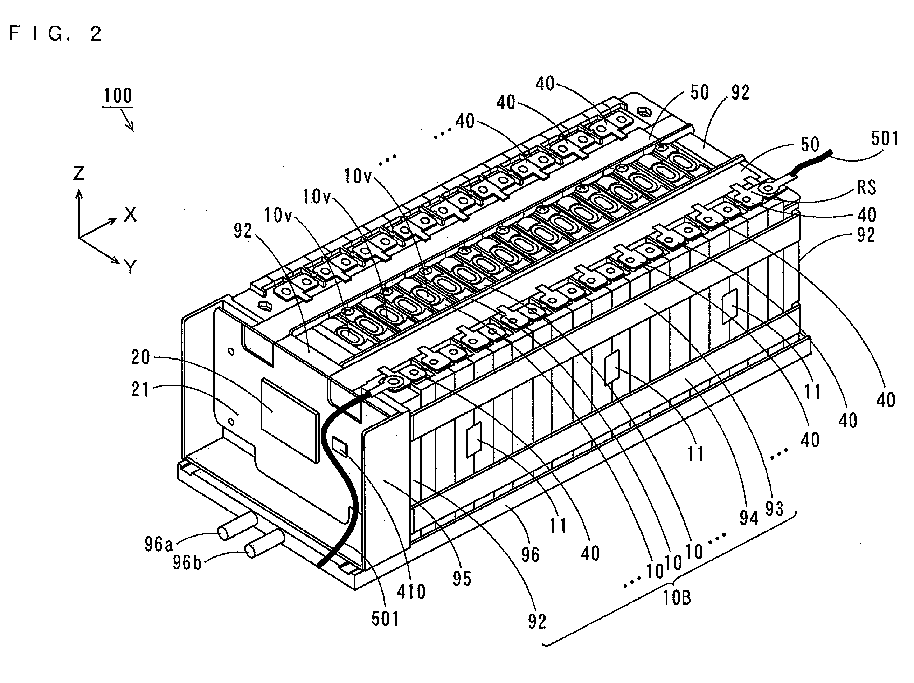

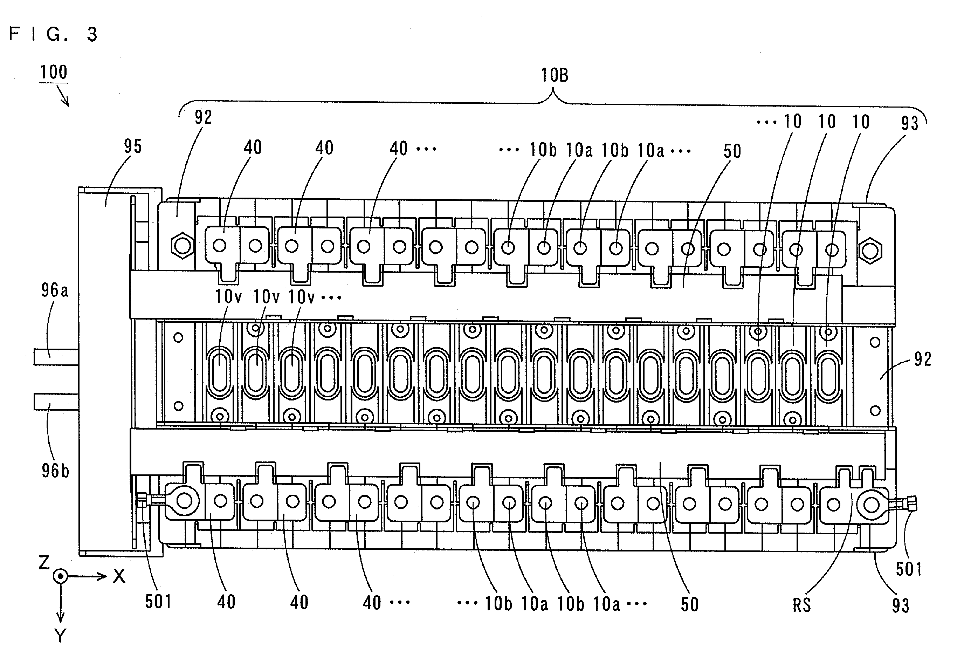

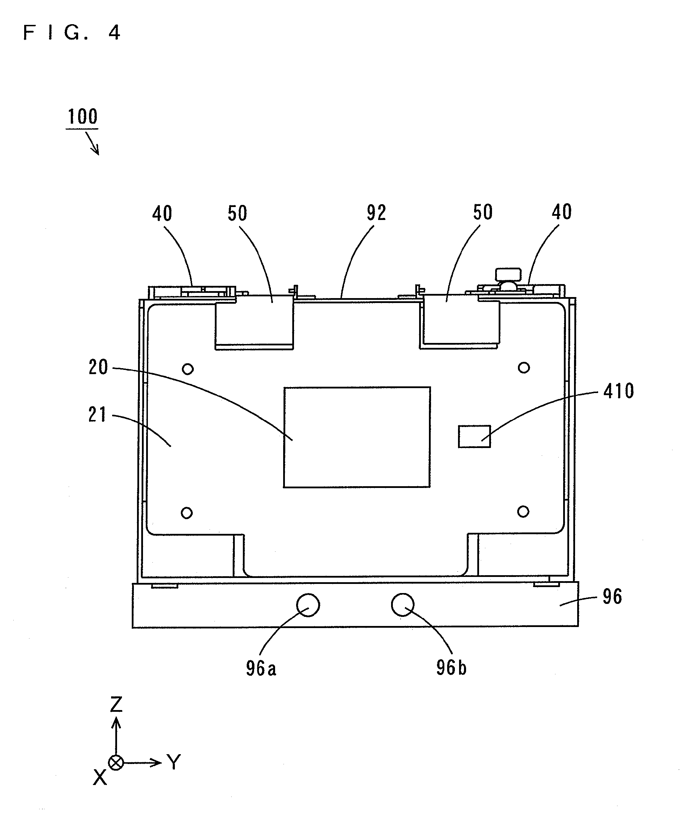

Details of the battery module 100 will be described. Fig. 2 is an external perspective view of the battery module 100, Fig. 3 is a plan view of the battery module 100, and Fig. 4 is a side view of the battery module 100.

In Figs. 2 to 4, and Figs. 7 to 12, and Fig. 18, described below, three directions that are perpendicular to one another are defined as an X-direction, a Y-direction, and a Z-direction, as indicated by arrows X, Y, and Z, respectively. In this example, the X-direction and the Y-direction are parallel to a horizontal plane, and the Z-direction is perpendicular to the horizontal plane.

As illustrated in Figs. 2 to 4, the plurality of battery cells 10 each having a flat and substantially rectangular parallelepiped shape are arranged to line up in the X-direction in the battery module 100. In this state, the plurality of battery cells 10 are integrally fixed by a pair of end surface frames 92, a pair of upper end frames 93, and a pair of lower end frames 94. Thus, the plurality of battery cells 10, the pair of end surface frames 92, the pair of upper end frames 93, and the pair of lower end frames 94 constitute a battery block 10B.

The pair of end surface frames 92 has a substantially plate shape, and is arranged parallel to a YZ plane. The pair of upper end frames 93 and the pair of lower end frames 94 are arranged to extend in the X-direction.

Connectors for connecting the pair of upper end frames 93 and the pair of lower end frames 94 are respectively formed at four corners of the pair of end surface frames 92. The pair of upper end frames 93 is attached to the upper connectors of the pair of end surface frames 92, and the pair of lower end frames 94 is attached to the lower connectors of the pair of end surface frames 92 with the plurality of battery cells 10 arranged between the pair of end surface frames 92. Thus, in the battery block 10B, the plurality of battery cells 10 are integrally fixed while being arranged to line up in the X-direction.

A rigid printed circuit board (hereinafter abbreviated as a printed circuit board) 21 is attached to one of the end surface frames 92. A protection member 95 having a pair of side surface portions and a bottom surface portion is attached to the end surface frame 92 to protect both ends and the bottom of the printed circuit board 21. The printed circuit board 21 is protected by being covered with the protection member 95. A detection circuit 20 and an amplification circuit 410 are provided on the printed circuit board 21.

A cooling plate 96 is provided to contact the plurality of battery cells 10 on a lower surface of the battery block 10B. The cooling plate 96 includes a refrigerant flow inlet 96a and a refrigerant flow outlet 96b. A circulation path that communicates with the refrigerant flow inlet 96a and the refrigerant flow outlet 96b is formed inside the cooling plate 96. When a refrigerant such as cooling water flows into the refrigerant flow inlet 96a, the refrigerant passes through the circulation path inside the cooling plate 96, and flows out of the refrigerant flow outlet 96b. Thus, the cooling plate 96 is cooled. As a result, the plurality of battery cells 10 are cooled.

The plurality of battery cells 10 each have a plus electrode 10a and a minus electrode 10b, respectively, on its upper surface portion on either of the one end side and the other end side in the Y-direction and its upper surface portion on the opposite end side. Each of the electrodes 10a and 10b is provided to protrude upward. The plus electrode 10a of the battery cell 10 is formed of aluminum. The minus electrode 10b of the battery cell 10 is formed of copper.

While the plus electrode 10a of the battery cell 10 is formed of aluminum in this example, it may be formed of an alloy of aluminum and another metal instead. Similarly, while the minus electrode 10b of the battery cell 10 is formed of copper, it may be formed of an alloy of copper and another metal instead.

Each of the plurality of battery cells 10 has a gas vent valve 10v at the center of the upper surface portion. If pressure inside the battery cell 10 rises to a predetermined value, gas inside the battery cell 10 is emitted from the gas vent valve 10v of the battery cell 10. Thus, the pressure inside the battery cell 10 is prevented from rising.

In the following description, the battery cell 10 adjacent to the one end surface frame 92 (the end surface frame 92 to which the printed circuit board 21 is attached) to the battery cell 10 adjacent to the other end surface frame 92 are respectively referred to as first to 18th battery cells 10.

In the battery module 100, the battery cells 10 are arranged so that a positional relationship between the plus electrode 10a and the minus electrode 10b in the Y-direction in one of the adjacent battery cells 10 is opposite to that in the other battery cell 10, as illustrated in Fig. 3.

Thus, in the adjacent two battery cells 10, the plus electrode 10a of the one battery cell 10 is in close proximity to the minus electrode 10b of the other battery cell 10, and the minus electrode 10b of the one battery cell 10 is in close proximity to the plus electrode 10a of the other battery cell 10. In this state, the bus bar 40 is attached to the two electrodes being in close proximity to each other. Thus, the plurality of battery cells 10 are connected in series.

More specifically, the common bus bar 40 is attached to the minus electrode 10b of the first battery cell 10 and the plus electrode 10a of the second battery cell 10. The common bus bar 40 is attached to the minus electrode 10b of the second battery cell 10 and the plus electrode 10a of the third battery cell 10.

Similarly, the common bus bar 40 is attached to the minus electrode 10b of each of the odd numbered battery cells 10 and the plus electrode 10a of each of the even numbered battery cells 10 adjacent thereto. The common bus bar 40 is attached to the minus electrode 10b of each of the even numbered battery cells 10 and the plus electrode 10a of each of the odd numbered battery cells 10 adjacent thereto.

On the other hand, the bus bar 40 for connecting the power supply line 501 from an external object is attached to each of the plus electrode 10a of the first battery cell 10 and the minus electrode 10b of the 18th battery cell 10. The bus bar 40 attached to the minus electrode 10b of the 18th battery cell 10 is used as a shunt resistor RS for current detection, described below.

A plurality of bus bars 40 are arranged in two rows along the X-direction on the battery block 10B. Two long-sized flexible printed circuit boards (hereinafter abbreviated as FPC boards) 50 extending in the X-direction are arranged inside the two rows of bus bars 40.

One of the FPC boards 50 is arranged between the gas vent valves 10v of the plurality of battery cells 10 and the plurality of bas bars 40 in one of the rows not to overlap the gas vent valves 10v of the plurality of battery cells 10. Similarly, the other FPC board 50 is arranged between the gas vent valves 10v of the plurality of battery cells 10 and the plurality of bus bars 40 in the other one row not to overlap the gas vent valves 10v of the plurality of battery cells 10.

The one FPC board 50 is connected in common to the plurality of bus bars 40 in one of the rows. Similarly, the other FPC board 50 is connected in common to the plurality of bus bars 40 in the other row.

Each of the FPC boards 50 has a configuration in which a plurality of conductor lines 51 and 52 (see Fig. 11, described below) are mainly formed on an insulating layer, and has bendability and flexibility. Examples of a material for the insulating layer composing the FPC board 50 include polyimide, and examples of a material for the conductor lines 51 and 52 include copper.

While copper is used as the material for the conductor lines 51 and 52 in this example, an alloy of copper and another metal may be used instead.

Each of the FPC boards 50 is folded downward at an upper end portion of one of the end surface frames 92, and is connected to the printed circuit board 21.

The plurality of bus bars 40 are connected to the detection circuit 20 via the plurality of conductor lines 51 with the FPC board 50 connected to the printed circuit board 21. The bus bar 40 attached to the battery cell 10 at the one end (the 18th battery cell 10 in this example) is connected to the amplification circuit 410 via the conductor line 51 and the conductor line 52, described below. Details thereof will be described below.

### (3) Structures of Bus Bar and FPC Board

Details of respective structures of a bus bar 40 and an FPC board 50 will be described below. A bus bar 40 for connecting a plus electrode 10a and a minus electrode 10b of the two adjacent battery cells 10 is referred to as a voltage bus bar 40x, and a bus bar 40 for connecting the battery cell 10 at one end (the 18th battery cell 10 in this example) and the power supply line 501 is referred to as a voltage/current bus bar 40y. The above-mentioned bus bar 40x is used as a bus bar for connecting the battery cell 10 at the other end (the first battery cell 10 in this example) and the power supply line 501.

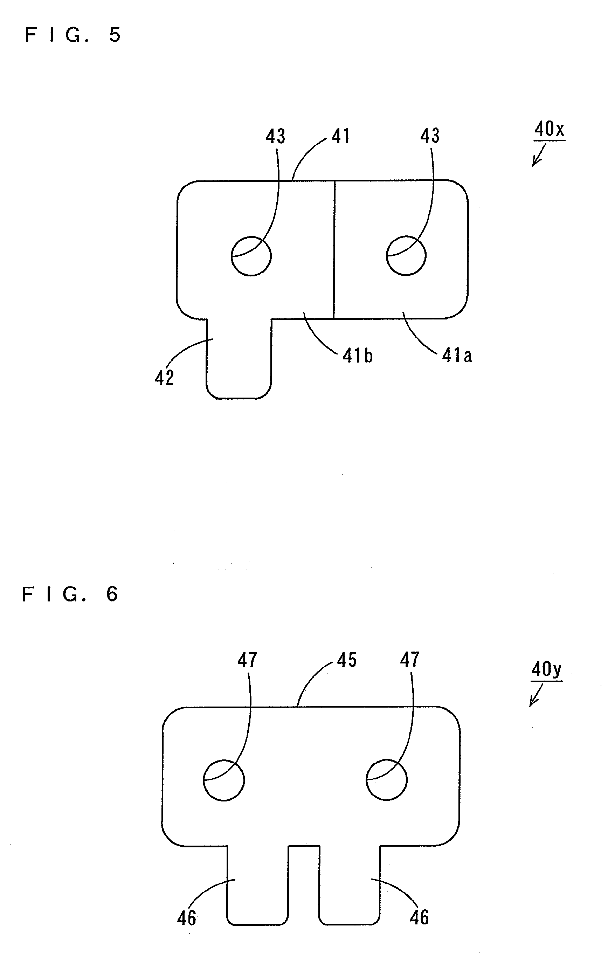

Fig. 5 is a plan view of the voltage bus bar 40x, and Fig. 6 is a plan view of the voltage/current bus bar 40y.

As illustrated in Fig. 5, the voltage bus bar 40x includes a base portion 41 having a substantially rectangular shape and an attachment portion 42. The base portion 41 is formed of a clad material having two types of metals crimped to each other. The base portion 41 is divided into two regions 41a and 41b. The region 41a in the base portion 41 is formed of aluminum, and the region 41b in the base portion 41 is formed of copper.

While the region 41a in the base portion 41 is formed of aluminum in this example, it may be formed of an alloy of aluminum and another metal instead. Similarly, while the region 41b in the base portion 41 is formed of copper, it may be formed of an alloy of copper and another metal instead.

The attachment portion 42 is formed to protrude from the long side of the region 41b in the base portion 41. Electrode connection holes 43 are respectively formed in the regions 41a and 41b in the base portion 41.

The voltage bus bars 40x in the one row illustrated in Figs. 2 and 3 are arranged with one surface of the voltage bus bar 40x illustrated in Fig. 5 directed upward, and the voltage bus bars 40x in the other one row are arranged with the other surface of the voltage bus bar 40x illustrated in Fig. 5 directed upward.

As illustrated in Fig. 6, the voltage/current bus bar 40y includes a base portion 45 having a substantially rectangular shape and a pair of attachment portions 46. The pair of attachment portions 46 is formed to be spaced apart from each other and protrude from the long side of the base portion 45. A pair of electrode connection holes 47 is formed in the base portion 45. The voltage/current bus bar 40y is formed of copper. A region leading from the one attachment portion 46 in the voltage/current bus bar 40y to the other attachment portion 46 via the base portion 45 is used as a shunt resistor RS (see Figs. 2 and 3). Details thereof will be described below.

While the voltage/current bus bar 40y is formed of copper in this example, it may be formed of an alloy of copper and another metal instead.

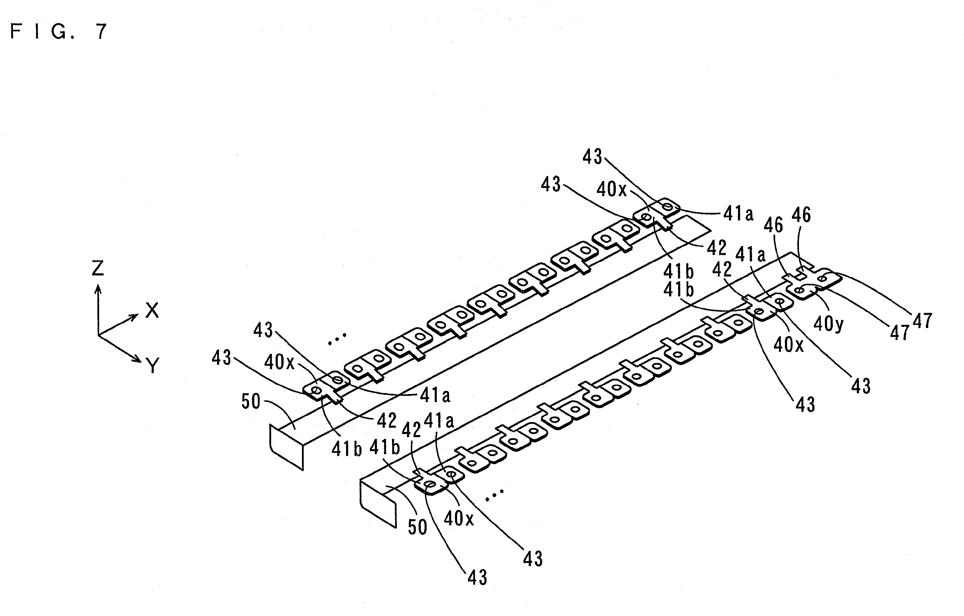

Fig. 7 is an external perspective view illustrating a state where the plurality of voltage bus bars 40x and the voltage/current bus bar 40y are attached to the FPC board 50. As illustrated in Fig. 7, the attachment portions 42 in the plurality of voltage bus bars 40x and the pair of attachment portions 46 in the voltage/current bus bar 40y are attached at a predetermined spacing along the X-direction to the two FPC boards 50.

When the battery module 100 is manufactured, the two FPC boards 50 each having the plurality of voltage bus bars 40x and the voltage/current bus bar 40y attached thereto, as described above, are provided on the battery block 10B.

The plus electrode 10a and the minus electrode 10b of the adjacent battery cells 10 are respectively fitted in the electrode connection hole 43 in the region 41a in the voltage bus bar 40x and the electrode connection hole 43 in the region 41b in the voltage bus bar 40x. In this state, the plus electrode 10a of the battery cell 10 is laser-welded to the region 41a in the voltage bus bar 40x while the minus electrode 10b thereof is laser-welded to the region 41b in the voltage bus bar 40x. Thus, the plurality of battery cells 10 and the plurality of voltage bus bars 40x are fixed to each other.

As described above, the plus electrode 10a of the battery cell 10 is formed of aluminum, and the minus electrode 10b thereof is formed of copper. The plus electrode 10a of the battery cell 10 is laser-welded to the region 41a in the voltage bus bar 40x composed of aluminum while the minus electrode 10b of the battery cell 10 is laser-welded to the region 41b in the voltage bus bar 40x composed of copper. In this case, no bimetallic corrosion occurs between the plus electrode 10a of the battery cell 10 and the voltage bus bar 40x and between the minus electrode 10b of the battery cell 10 and the voltage bus bar 40x. As a result, the durability and the reliability of the battery module 100 are improved.

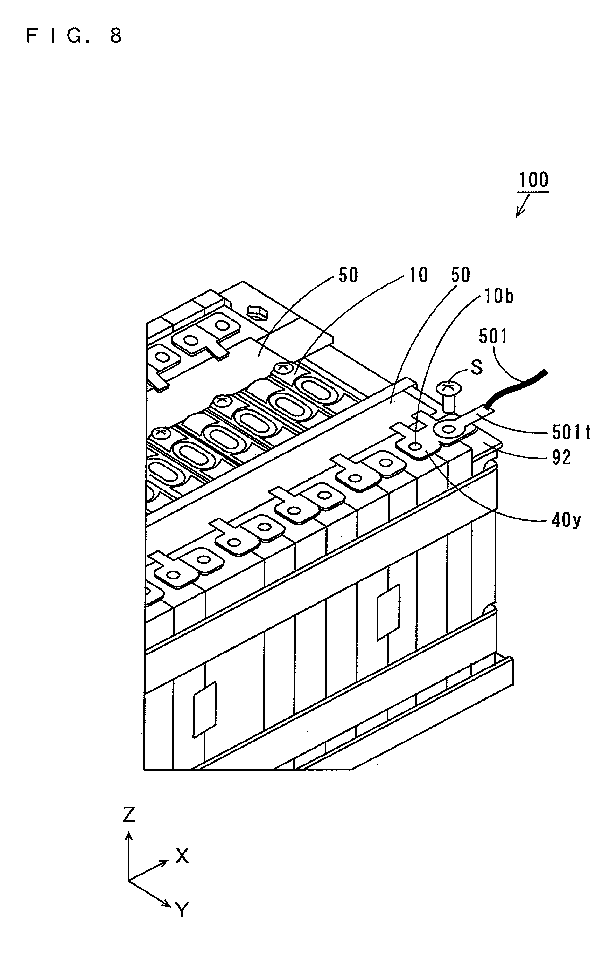

Fig. 8 is an external perspective view at one end of the battery module 100. As illustrated in Fig. 8, the power supply line 501 is connected to the minus electrode 10b of the battery cell 10 at the one end (the 18th battery cell 10 in this example) via the voltage/current bus bar 40y. The power supply line 501 has a ring terminal 501t composed of copper, for example, at its end.

While the power supply line 501 and the ring terminal 501t are formed of copper in this example, it may be formed of an alloy of copper and another metal instead.

The minus electrode 10b of the battery cell 10 at the one end is fitted in the one electrode connection hole 47 (see Fig. 6) in the voltage/current bus bar 40y. In this state, the minus electrode 10b of the battery cell 10 at the one end is laser-welded to the voltage/current bus bar 40y. Thus, the voltage/current bus bar 40y is fixed to the minus electrode 10b of the battery cell 10 at the one end while the voltage/current bus bar 40y is electrically connected to the minus electrode 10b of the battery cell 10.

A screw S is threadably mounted on a screw hole formed in the one end surface frame 92 in the battery module 100 through a through hole in the ring terminal 501t of the power supply line 501 and the other electrode connection hole 43 (see Fig. 6) in the voltage/current bus bar 40y. Thus, the voltage/current bus bar 40y is fixed to the one end surface frame 92 while the voltage/current bus bar 40y is electrically connected to the ring terminal 501t of the power supply line 501.

As described above, the minus electrode 10b of the battery cell 10 at the one end is laser-welded to the voltage/current bus bar 40y composed of copper. The ring terminal 501t of the power supply line 501 is attached to the voltage/current bus bar 40y composed of copper.

In this case, no bimetallic corrosion occurs between the minus electrode 10b of the battery cell 10 at the one end and the voltage/current bus bar 40y and between the ring terminal 501t of the power supply line 501 and the voltage/current bus bar 40y. The voltage/current bus bar 40y is fixed to the one end surface frame 92 with the screw S. Even if tension is put on the power supply line 501, therefore, the FPC board 50 is prevented from being damaged and the voltage/current bus bar 40y is prevented from being stripped from the FPC board 50. As a result, the durability and the reliability of the battery module 100 are improved.

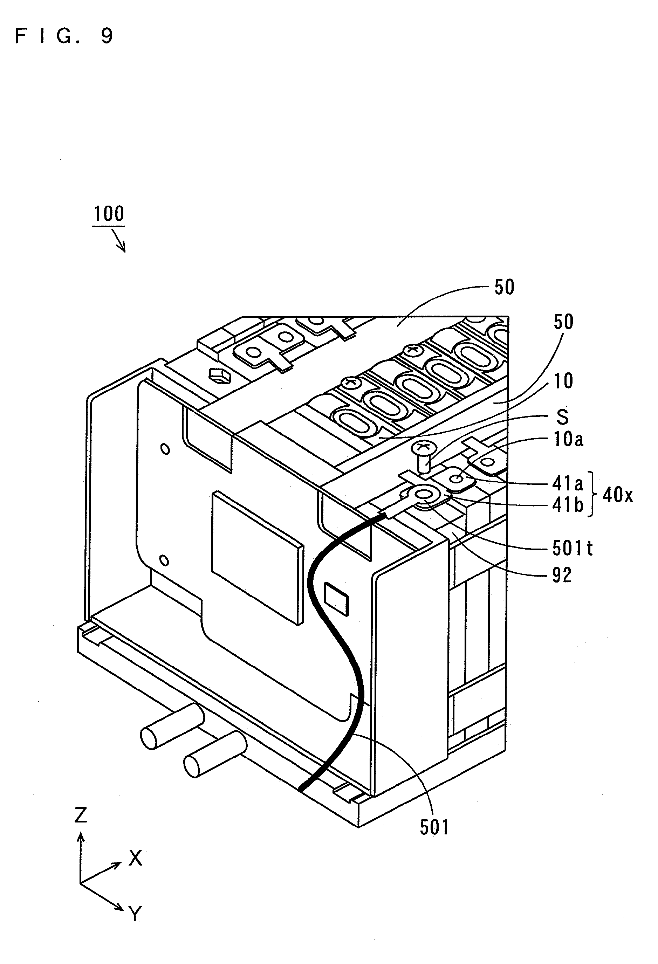

Fig. 9 is an external perspective view at the other end of the battery module 100. As illustrated in Fig. 9, the power supply line 501 is connected to the plus electrode 10a of the battery cell 10 at the other end (the first battery cell 10 in this example) via the voltage bus bar 40x.

The plus electrode 10a of the battery cell 10 at the other end is fitted in the electrode connection hole 43 (see Fig. 5) in the region 41a in the voltage bus bar 40x. In this state, the plus electrode 10a of the battery cell 10 at the other end is laser-welded to the region 41a in the voltage bus bar 40x. Thus, the voltage bus bar 40x is fixed to the plus electrode 10a of the battery cell 10 at the other end while the region 41a in the voltage bus bar 40x is electrically connected to the plus electrode 10a of the battery cell 10.

A screw S is threadably mounted on a screw hole formed in the other end surface frame 92 in the battery module 100 through a through hole in the ring terminal 501t of the power supply line 501 and the electrode connection hole 43 (see Fig. 5) in the region 41b in the voltage bus bar 40x. Thus, the voltage bus bar 40x is fixed to the other end surface frame 92 while the region 41b in the voltage bus bar 40x is electrically connected to the ring terminal 501t of the power supply line 501.

As described above, the plus electrode 10a of the battery cell 10 at the other end is laser-welded to the region 41a in the voltage bus bar 40x composed of aluminum. The ring terminal 501t of the power supply line 501 is attached to the region 41b in the voltage bus bar 40x composed of copper.

In this case, no bimetallic corrosion occurs between the plus electrode 10a of the battery cell 10 at the other end and the voltage bus bar 40x and between the ring terminal 501t of the power supply line 501 and the voltage bus bar 40x. The voltage bus bar 40x is fixed to the other end surface frame 92 with the screw S. Even if tension is put on the power supply line 501, therefore, the FPC board 50 is prevented from being damaged and the voltage bus bar 40x is prevented from being stripped from the FPC board 50. As a result, the durability and the reliability of the battery module 100 are improved.

Thus, the plurality of voltage bus bars 40x and the voltage/current bus bar 40y are attached to the plurality of battery cells 10 while the plurality of voltage bus bar 40x and the voltage/current bus bar 40y hold the FPC board 50 in a substantially horizontal posture.

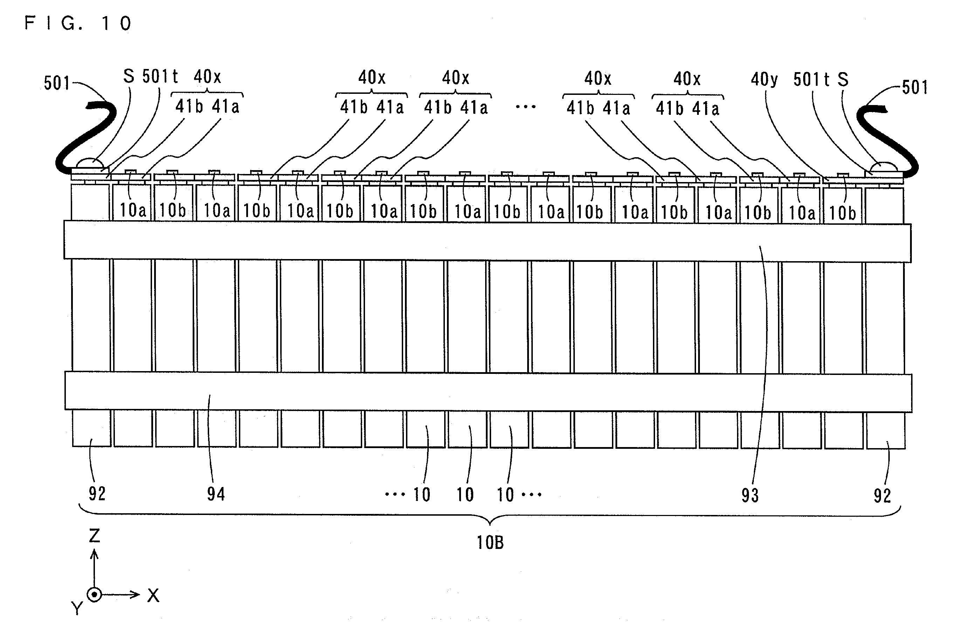

Fig. 10 is a side view of the battery block 10B. As described above, the plurality of voltage bus bars 40x and the voltage/current bus bar 40y are laser-welded to the plus electrodes 10a and the minus electrodes 10b of the battery cells 10. Therefore, a connection member for connecting the plurality of voltage bus bars 40x and the voltage/current bus bar 40y with the battery cells 10 is not required. Thus, the size in a height direction (Z-direction) of the battery block 10B can be reduced.

### (4) Connection of Bus Bar and FPC Board with Detection Circuit

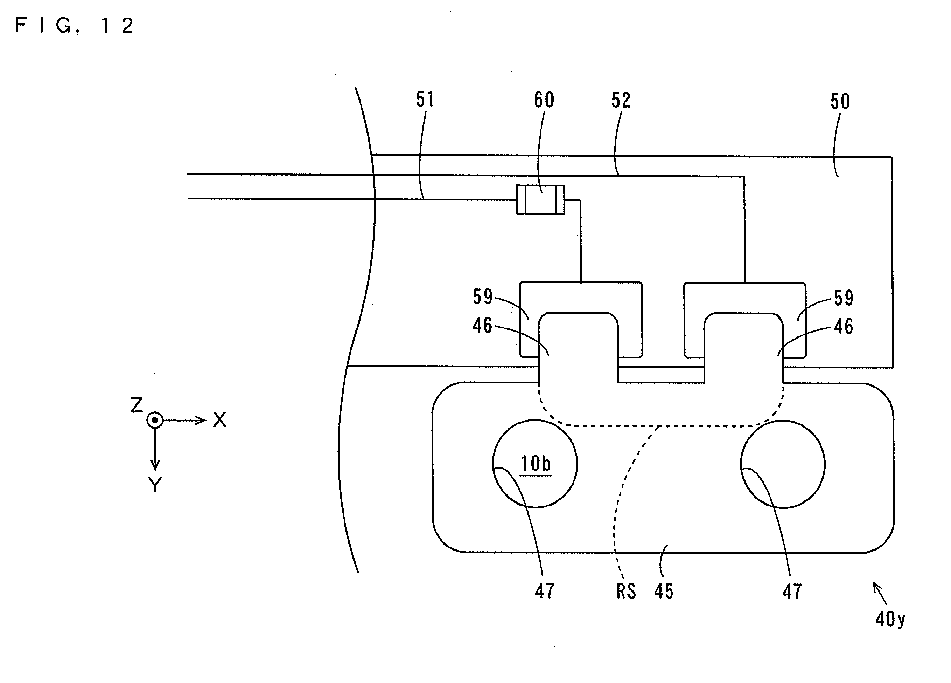

Soldering in the battery module 100 according to the present embodiment will be described in detail below. Connection of the plurality of voltage bus bars 40x and the voltage/current bus bar 40y with the detection circuit 20 will be described. Figs. 11 and 12 are schematic plan views for illustrating connection of the plurality of voltage bus bars 40x and the voltage/current bus bar 40y with the detection circuit 20.

As illustrated in Fig. 11, the one FPC board 50 is connected in common to the plurality of voltage bus bars 40x in one of the rows. The other FPC board 50 is connected in common to the plurality of voltage bus bars 40x and the voltage/current bus bar 40y in the other row. The one FPC board 50 is provided with a plurality of conductive plates 59, a plurality of conductor lines 51, and a plurality of PTC elements 60 respectively corresponding to the attachment portions 42 in the plurality of voltage bus bars 40x. The attachment portions 42 in the plurality of voltage bus bars 40x are respectively attached to the corresponding conductive plates 59 on the one FPC board 50 by soldering.

The conductive plates 59 corresponding to the attachment portions 42 in the plurality of voltage bus bars 40x are connected to the detection circuit 20 via the conductor lines 51 and a conductor line on the printed circuit board 21. Thus, the plurality of voltage bus bars 40x are electrically connected to the detection circuit 20.

Similarly, the other FPC board 50 is provided with a plurality of conductive plates 59, a plurality of conductor lines 51, and a plurality of PTC elements 60 respectively corresponding to the attachment portions 42 in the plurality of voltage bus bars 40x. The other FPC board 50 is provided with a conductive plate 59, a conductor line 51, and a plurality of PTC elements 60 corresponding to the one attachment portion 46 in the voltage/current bus bar 40y. Further, the other FPC board 50 is provided with a conductive plate 59 and a conductor line 52 corresponding to the other attachment portion 46 in the voltage/current bus bar 40y.

The attachment portions 42 in the plurality of voltage bus bars 40x and the pair of attachment portions 46 in the voltage/current bus bar 40y are attached to the corresponding conductive plate 59 on the other FPC board 50 by soldering.

The conductive plates 59 corresponding to the attachment portions 42 in the plurality of voltage bus bars 40x are connected to the detection circuit 20 via the conductor lines 51 and a conductor line on the printed circuit board 21. Thus, the plurality of voltage bus bars 40x are electrically connected to the detection circuit 20.

The plurality of conductor lines 51 and the conductive plates 59 are formed of copper. While the conductive plate 59 is formed of copper in this example, it may be formed of an alloy of copper and another metal (a copper alloy) instead.

The region 41b in the base portion 41 in the voltage bus bar 40x and the voltage/current bus bar 40y to be soldered to the conductive plate 59 are also formed of copper or a copper alloy. In this case, the conductive plates 59 in the FPC board 50 are soldered to the regions 41b in the base portions 41 in the voltage bus bars 40x and the voltage/current bus bar 40y, thereby coppers or copper alloys are connected with each other. Therefore, the connection is more rigid than when aluminum or an alloy of aluminum and another metal (an aluminum alloy) is soldered to copper or a copper alloy.

From the above-mentioned reason, in connection of the plurality of voltage bus bars 40x and the voltage/current bus bar 40y with the FPC board 50, the voltage bus bar 40x is used as a bus bar for connecting the battery cell 10 at the other end and the power supply line 501.

More specifically, as a bus bar for connecting the power supply line 501 and the plus electrode 10a of the battery cell 10 at the other end, a bus bar formed of aluminum or an aluminum alloy can also be used. However, to rigidly connect the bus bar and the FPC board 50, the voltage bus bar 40x composed of a clad material is used as a bus bar for connecting the power supply line 501 and the plus electrode 10a of the battery cell 10 at the other end.

As described above, in this example, the attachment portions 42 in the plurality of voltage bus bars 40x composed of copper or a copper alloy and the pair of attachment portions 46 in the voltage/current bus bar 40y are respectively soldered to the conductive plates 59 in the FPC board 50. Therefore, no bimetallic corrosion occurs between the attachment portions 42 in the plurality of voltage bus bars 40x and the attachment portion 46 in the voltage/current bus bar 40y and the conductive plates 59 in the FPC board 50. Thus, the durability and the reliability of the battery module 100 are improved.

The PTC element 60 is inserted through the conductor line 51. The PTC element 60 has a resistance temperature characteristic in which its resistance value rapidly increases when a temperature exceeds a certain value. When a short occurs in the detection circuit 20 and the conductor line 51, for example, therefore, the temperature of the PTC element 60 rises due to a current flowing through a short-circuit path so that the resistance value of the PTC element 60 increases. Thus, a large current is prevented from flowing in the short-circuit path including the PTC element 60.

As illustrated in Fig. 12, a region leading from the one attachment portion 46 in the voltage/current bus bar 40y to the other attachment portion 46 via the base portion 45 is used as a shunt resistor RS. A resistance value of the shunt resistor RS between the one conductive plate 59 and the other conductive plate 59 is previously set.

As illustrated in Fig. 11, the conductor line 51 corresponding to the voltage/current bus bar 40y is connected to the one input terminal of the amplification circuit 410 and the detection circuit 20 via the conductor line on the printed circuit board 21. On the other hand, the conductor line 52 corresponding to the voltage/current bus bar 40y is connected to the other input terminal of the amplification circuit 410 via the conductor line on the printed circuit board 21. An output terminal of the amplification circuit 410 is connected to the detection circuit 20 via the conductor line 53 on the printed circuit board 21.

Thus, the detection circuit 20 detects a voltage between terminals of each of the battery cells 10 based on voltages of the plurality of voltage bus bars 40x and the voltage/current bus bar 40y.

The detection circuit 20 detects a voltage value between both ends of the shunt resistor RS based on an output voltage of the amplification circuit 410. The voltage value detected by the detection circuit 20 is given to the battery ECU 101 illustrated in Fig. 1.

The battery ECU 101 includes a CPU (Central Processing Unit) and a memory, for example. In the present embodiment, the resistance value of the shunt resistor RS in the voltage/current bus bar 40y is previously stored in the memory in the battery ECU 101.

The battery ECU 101 divides the voltage value between both ends of the shunt resistor RS, which has been given from the detection circuit 20, by the resistance value of the shunt resistor RS stored in the memory, to calculate a value of a current flowing through the voltage/current bus bar 40y.

The resistance value of the shunt resistor RS may be previously calculated based on the length and the cross section area of a current path, and the calculated value may be stored in the memory in the battery ECU 101. Alternatively, the resistance value of the shut resistor RS may be previously measured, and the measured value may be stored in the memory in the battery ECU 101. Further, the thermistor 11 may detect the temperature of the voltage/current bus bar 40y, and the resistance value of the shunt resistor RS stored in the memory in the battery ECU 101 may be corrected by the detected temperature.

### (5) Example of One Configuration of Detection Circuit and Amplification Circuit

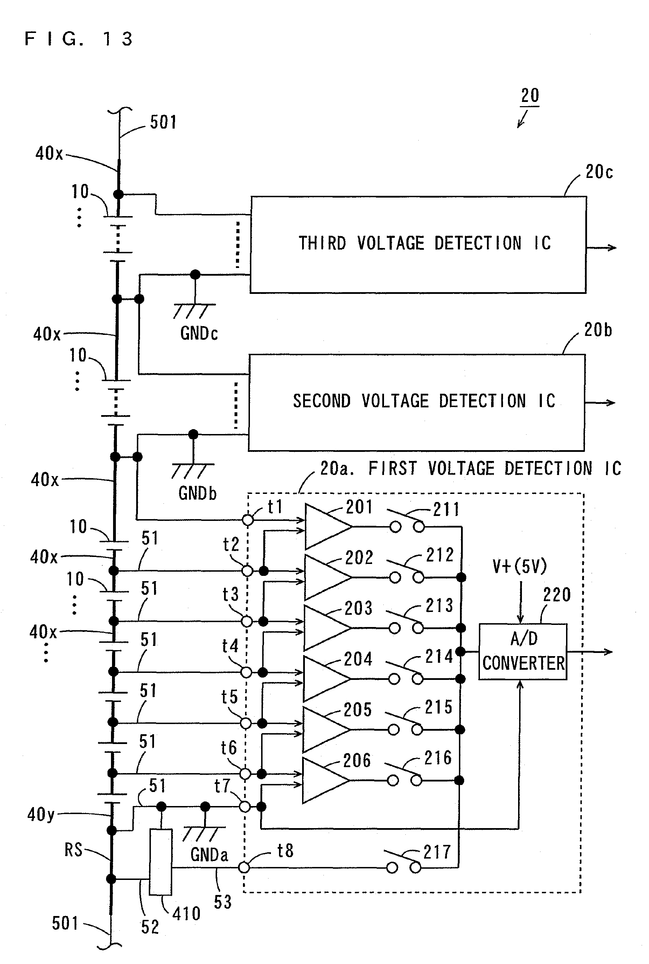

Fig. 13 is a circuit diagram illustrating an example of one configuration of the detection circuit 20 illustrated in Fig. 1. The detection circuit 20 illustrated in Fig. 13 includes first, second, and third voltage detection ICs (integrated circuits) 20a, 20b, and 20c. In this example, the first voltage detection IC 20a is provided to correspond to the 18th to 13th battery cells 10, the second voltage detection IC 20b is provided to correspond to the 12th to 7th battery cells 10, and the third voltage detection IC 20c is provided to correspond to the 6th to first battery cells 10. An amplification circuit 410 is connected to the first voltage detection IC 20a. Reference voltages GNDa, GNDb, and GNDc of the first to third voltage detection ICs 20a, 20b, and 20c are respectively electrically independent of one another.

The first voltage detection IC 20a will be typically described below. The second and third voltage detection ICs 20b and 20c have the same configuration as that of the first voltage detection IC 20a.

The first voltage detection IC 20a has eight input terminals t1 to t8. The input terminal t7 is held at the reference voltage GNDa. The input terminals t7 to t1 are respectively connected to the voltage bus bars 40x provided among the 18th to 13th battery cells 10 and the voltage/current bus bar 40y provided in the 18th battery cell 10 via the conductor lines 51. The input terminal t8 is connected to the output terminal of the amplification circuit 410 illustrated in Fig. 11 via the conductor line 53. The one input terminal of the amplification circuit 410 is connected to one end of the shunt resistor RS of the voltage/current bus bar 40y via the conductor line 51, and the other input terminal of the amplification circuit 410 is connected to the other end of the shunt resistor RS of the voltage/current bus bar 40y via the conductor line 52.

The first voltage detection IC 20a includes voltage detectors 201 to 206, switching elements 211 to 217, and an A/D (Analog/Digital) converter 220.

The voltage detector 201 differentially amplifies a voltage between the input terminals t1 and t2, the voltage detector 202 differentially amplifies a voltage between the input terminals t2 and t3, the voltage detector 203 differentially amplifies a voltage between the input terminals t3 and t4, the voltage detector 204 differentially amplifies a voltage between the input terminals t4 and t5, the voltage detector 205 differentially amplifies a voltage between the input terminals t5 and t6, and the voltage detector 206 differentially amplifies a voltage between the input terminals t6 and t7. Further, the amplification circuit 410 amplifies a voltage between both ends of the shunt resistor RS.

Output terminals of the voltage detectors 201 to 206 and the input terminal t8 are connected to an input terminal of the A/D converter 220 via the switching elements 211 to 217, respectively. The reference voltage GNDa at the input terminal t7 is fed to a reference terminal of the A/D converter 220, and a power supply voltage V+ is fed to a power supply terminal of the A/D converter 220.

While the reference voltage GNDa at the input terminal t7 is fed in common to the voltage detector 206 and the A/D converter 220 in this example, the reference voltage GNDa may be fed to the reference terminal of the A/D converter 220 separately from the voltage detector 206.

The switching elements 211 to 217 are sequentially turned on. Thus, the voltages respectively amplified by the voltage detectors 201 to 206 and the amplification circuit 410 are sequentially fed to the A/D converter 220. The A/D converter 220 converts the fed voltage into a digital voltage value. The digital voltage value obtained by the A/D converter 220 is given to the battery ECU 101 illustrated in Fig. 1.

In the battery ECU 101, the charged capacity of each of the battery cells 10 is calculated based on a voltage value between terminals of the battery cell 10, as described above. A value of a current flowing through the voltage/current bus bar 40y is calculated based on a value of a voltage between both ends of the shunt resistor RS and a resistance value of the shunt resistor RS.

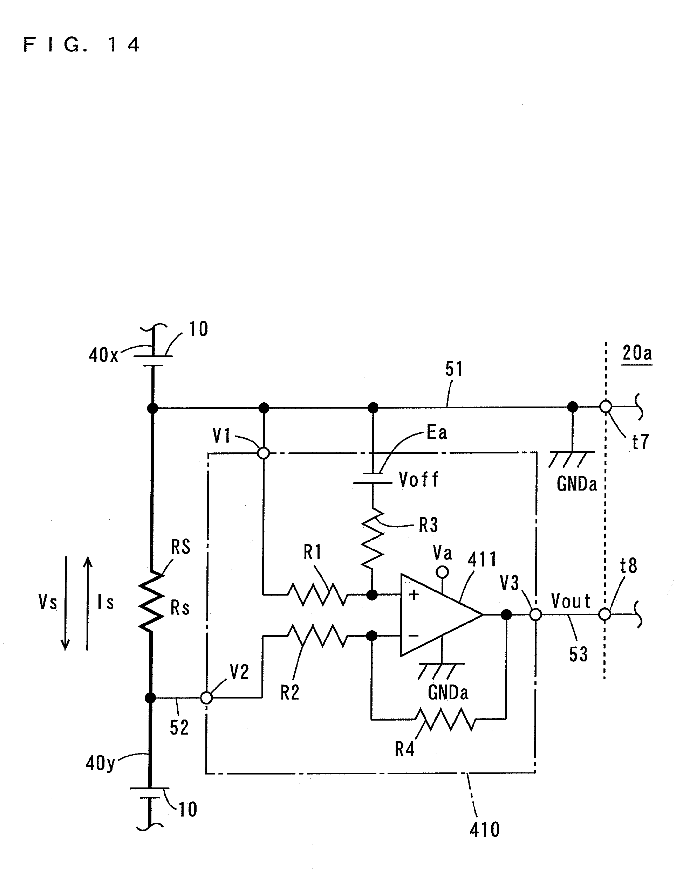

Fig. 14 is a circuit diagram illustrating an example of one configuration of the amplification circuit 410 illustrated in Fig. 13. Details of the amplification circuit 410 provided to correspond to the first voltage detection IC 20a illustrated in Fig. 13 will be described below. The resistance value of the shunt resistor RS is referred to as a shunt resistance value Vs, the voltage value between both ends of the shunt resistor RS is referred to as a voltage value Vs, and a value of a current flowing through the shunt resistor RS is referred to as a current value Is.

If the shunt resistance value Rs has already been known, the current value Is can be calculated by detecting the voltage value Vs.

Since the voltage/current bus bar 40y is mainly composed of copper, as described above, the shunt resistance value Rs is small (e.g., approximately 1 mΩ). In this case, the current value Is varies in a range from - 100 A to 100 A, for example, and the voltage value Vs varies in a range of - 0.1 V to 0.1 V. Since the direction of the current flowing through the voltage/current bus bar 40y at the time of charge is opposite to that at the time of discharge, the current value Is and the voltage value Vs become negative.

The first voltage detection IC 20a detects a voltage between terminals of each of the battery cells 10 that varies in a range from 2.5 V to approximately 4.2 V, for example. On the other hand, the voltage value Vs between both ends of the shunt resistor RS is lower than the voltage between the terminals of each of the battery cells 10. In the present embodiment, the amplification circuit 410 amplifies the voltage value Vs between both ends of the shunt resistor RS.

Input terminals V1 and V2 and an output terminal V3 of the amplification circuit 410 are respectively connected to the conductor lines 51, 52, and 53. The amplification circuit 410 includes an operation amplifier 411, a direct current (DC) power supply Ea, and resistors R1 to R4.

A non-inverting input terminal of the operational amplifier 411 is connected to the input terminal V1 via the resistor R1 while being connected to a positive electrode of the DC power supply Ea via the resistor R3. An inverting input terminal of the operational amplifier 411 is connected to the input terminal V2 via the resistor R2. The resistor R4 is connected between the non-inverting input terminal of the operational amplifier 411 and the output terminal V3. A reference voltage GNDa is fed to a reference terminal of the operational amplifier 411, and a power supply voltage Va is fed to a power supply terminal thereof.

A positive electrode voltage (hereinafter referred to as an offset voltage) Voff of the DC power supply Ea is set to a voltage intermediate between the reference voltage GNDa and the power supply voltage Va. If the voltage value Vs varies within a range between a negative value and a positive value, therefore, a voltage value Vout at the output terminal of the amplification circuit 410 varies within a range between 0 V and the power supply voltage Va around the offset voltage Voff.

For example, values of the resistors R1 and R2 are set to 10 kΩ, and values of the resistors R3 and R4 are set to 250 kΩ. In this case, an amplification gain of the amplification circuit 410 is 25. The power supply voltage Va is 5 V, and the offset voltage Voff is 2.5 V. If the shunt resistance value Rs is approximately 1 mΩ, as described above, the amplification circuit 410 amplifies the voltage value Vs, which varies in a range from - 0.1 V to 0.1 V, to a voltage within a range from 0 V to 5 V around 2.5 V.

If the voltage value Vs is - 0.1 V, the output voltage of the amplification circuit 410 is 5 V. In this case, the current value Is is calculated to be - 100 A. If the voltage value Vs is 0 V, the output voltage of the amplification circuit 410 is 2.5 V. In this case, the current value Is is calculated to be 0 A. Further, if the voltage value Vs is 0.1 V, the output voltage of the amplification circuit 410 is 0 V. In this case, the current value Is is calculated to be 100 A.

The reason why the voltage/current bus bar 40y connected to the minus electrode 10b of the battery cell 10 at the one end (the 18th battery cell 10 in this example) is used as the shunt resistor RS for current detection will be described.

The voltage bus bar 40x can also be used as the shunt resistor RS. However, the voltage bus bar 40x for connecting the plus electrode 10a and the minus electrode 10b of the adjacent two battery cells 10 is formed of a clad material composed of the same aluminum as that forming the plus electrode 10a and the same copper as that forming the minus electrode 10b. The voltage bus bar 40x formed of the clad material is higher in cost than a bus bar formed of one type of metal. Therefore, in the present embodiment, a low-cost voltage/current bus bar 40y formed of one type of metal is used as the shunt resistor RS for current detection.

The shunt resistance value Rs is set by adjusting a material for the bus bar and dimensions thereof. The dimensions include the length and the cross section area of the current path. More specifically, the shunt resistance value Rs is limited by the dimensions of the bus bar. The dimensions of the voltage bus bar 40x are limited by a distance between the plus electrode 10a and the minus electrode 10b of the adjacent two battery cells 10. If the thickness of each of the battery cells 10 is small, the length of the voltage bus bar 40x is also reduced. If the voltage bus bar 40x is used as the shunt resistor RS, therefore, it becomes difficult to optimally set the shunt resistance value Rs. Therefore, in the present embodiment, the voltage/current bus bar 40y is attached to the battery cell 10 at the one end so that the dimensions of the shunt resistor RS are not limited by the thickness of the battery cell 10.

On the other hand, a bus bar connected to the plus electrode 10a of the battery cell 10 at the other end can be formed of aluminum, and the bus bar can be used as the shunt resistor RS. However, in this case, the ring terminal 501t of the power supply line 501 is connected to the bus bar composed of aluminum. The ring terminal 501t of the power supply line 501 and the power supply line 501 need to be composed of aluminum to prevent bimetallic corrosion from occurring between the ring terminal 501t and the bus bar 40. In the present embodiment, the voltage/current bus bar 40y composed of copper is attached to not the plus electrode 10a of the battery cell 10 at the other end but the minus electrode 10b of the battery cell 10 at the one end.

### (6) Another Example of Configuration of Detection Circuit

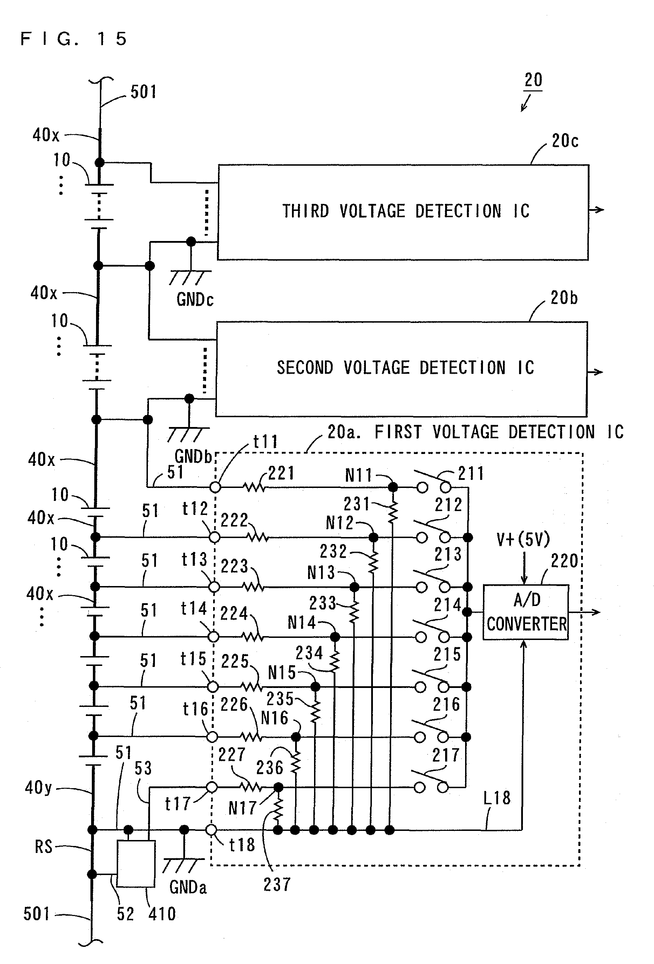

The detection circuit 20 illustrated in Fig. 1 may have the following configuration instead of the configuration illustrated in Fig. 13. Fig. 15 is a circuit diagram illustrating another example of the configuration of the detection circuit 20 illustrated in Fig. 1.

The detection circuit 20 illustrated in Fig. 15 includes first, second, and third voltage detection ICs 20a, 20b, and 20c having the same configuration. Details of the first voltage detection IC 20a in this example will be described below.

The first voltage detection IC 20a has eight input terminals t11 to t18. The input terminal t18 is held at a reference voltage GNDa. The input terminals t18 and t16 to t11 are respectively connected to the voltage bus bars 40x provided among the 18th to 13th battery cells 10 and the voltage/current bus bar 40y provided in the 18th battery cell 10 via conductor lines 51. The input terminal t17 is connected to an output terminal of the amplification circuit 410 illustrated in Fig. 11 via a conductor line 53.

A configuration of the amplification circuit 410 illustrated in Fig. 15 is the same as the configuration of the amplification circuit 410 illustrated in Fig. 14. Therefore, the voltage value Vs between both ends of a shunt resistor RS amplified by the amplification circuit 410 is input to the input terminal t17.

The first voltage detection IC 20a includes resistors 221 to 227 and 231 to 237, switching elements 211 to 217, and an A/D converter 220.

The resistors 221 and 231 are connected in series between the input terminal t11 and the input terminal t18, the resistors 222 and 232 are connected in series between the input terminal t12 and the input terminal t18, and the resistors 223 and 233 are connected in series between the input terminal t13 and the input terminal t18.

The resistors 224 and 234 are connected in series between the input terminal t14 and the input terminal t18, the resistors 225 and 235 are connected in series between the input terminal t15 and the input terminal t18, the resistors 226 and 236 are connected in series between the input terminal t16 and the input terminal t18, and resistors 227 and 237 are connected in series between the input terminal t17 and the input terminal t18. Thus, each of respective voltages at the input terminals t11 to t17 is divided.

A node N11 between the resistors 221 and 231, a node N12 between the resistors 222 and 232, a node N13 between the resistors 223 and 233, a node N14 between the resistors 224 and 234, a node N15 between the resistors 225 and 235, a node N16 between the resistors 226 and 236, and a node N17 between the resistors 227 and 237 are connected to an input terminal of the A/D converter 220 via the switching elements 211 to 217, respectively. The reference voltage GNDa at the input terminal t18 is fed to a reference terminal of the A/D converter 220, and a power supply voltage V+ is fed to a power supply terminal of the A/D converter 220.

The switching elements 211 to 217 are sequentially turned on. Thus, voltages at the nodes N11 to N17 are sequentially fed to the A/D converter 220.

The resistors 221 and 227 and the resistors 231 to 237 are set so that the voltages at the nodes N11 to N17 become a power supply voltage V+ or less from the reference voltage GNDa of the A/D converter 220.

The A/D converter 220 converts the fed voltage to a digital voltage value. The digital voltage value obtained by the A/D converter 220 is given to the battery ECU 101 illustrated in Fig. 1.

Thus, the battery ECU 101 calculates a charged capacity of each of the battery cells 10 based on a voltage value of the battery cell 10, like in the one example of the configuration of the detection circuit 20 illustrated in Fig. 13. A value Is of a current flowing through the voltage/current bus bar 40y is calculated based on the voltage value Vs between both ends of the shunt resistor RS and a shunt resistance value Rs.

### (7) Effects

In the battery module 100 according to the first embodiment, a part of the voltage/current bus bar 40y attached to the minus electrode 10b of the battery cell 10 at the one end is used as the shunt resistor RS for current detection. Thus, the shape and the dimensions of the shunt resistor RS are not limited by a spacing between the adjacent battery cells 10. Therefore, the shunt resistor RS can be easily set to its optimum value. The battery module 100 need not be separately provided with a shunt resistor. As a result, the current flowing through the battery module 100 can be detected in a simple configuration without increasing the size of the battery module 100.

In the first embodiment, the one attachment portion 46 in the voltage/current bus bar 40y corresponding to the one end of the shunt resistor RS is electrically connected to the detection circuit 20 via the conductor line 51 in the FPC board 50 while the other attachment portion 46 in the voltage/current bus bar 40y corresponding to the other end of the shunt resistor RS is electrically connected to the detection circuit 20 via the conductor line 52 in the FPC board 50. Thus, the detection circuit 20 can detect a voltage between both ends of the shunt resistor RS.

The FPC board 50 is provided to extend along the plurality of voltage bus bars 40x and the voltage/current bus bar 40y. In this case, the plurality of voltage bus bars 40x and the voltage/current bus bar 40y can be easily connected to the FPC board 50. Thus, the detection circuit 20 can detect the voltage between the terminals of each of the battery cells 10 without complicating wiring.

Further, the battery ECU 101 in the battery system 500 calculates the current flowing through the shunt resistor RS based on the voltage between both ends of the shunt resistor RS, which has been detected by the detection circuit 20. Thus, the current flowing through the battery module 100 can be detected in a simpler configuration.

The voltage/current bus bar 40y is laser-welded to the minus electrode 10b of the battery cell 10 at the one end while being fixed to the one end surface frame 92 with the screw S. The screw S is used as an output terminal for outputting electric power from the battery module 100 to the external object. Thus, the battery block 10B need not be provided with an additional terminal to connect the shunt resistor RS. Therefore, the battery module 100 can be provided with the shunt resistor RS without increasing a manufacturing process and a manufacturing cost.

The minus electrode 10b of each of the battery cells 10, the region 41b in the voltage bus bar 40x, and the voltage/current bus bar 40y are formed of copper, and the plus electrode 10a of each of the battery cells 10 and the region 41a in the voltage bus bar 40x are formed of aluminum. No bimetallic corrosion occurs between the region 41b in the voltage bus bar 40x and the minus electrode 10b of the one buttery cell 10, between the region 41a in the voltage bus bar 40x and the plus electrode 10a of the other battery cell 10, and between the voltage/current bus bar 40y and the one electrode of the battery cell 10 at the one end. As a result, the durability and the reliability of the battery module 100 are improved.

In this case, the ring terminal 501t and the power supply line 501 can be formed of copper. Thus, a special configuration for preventing the bimetallic corrosion need not be used for the ring terminal 501t and the power supply line 501. As a result, the cost can be prevented from increasing by providing the voltage/current bus bar 40y with the shunt resistor RS.

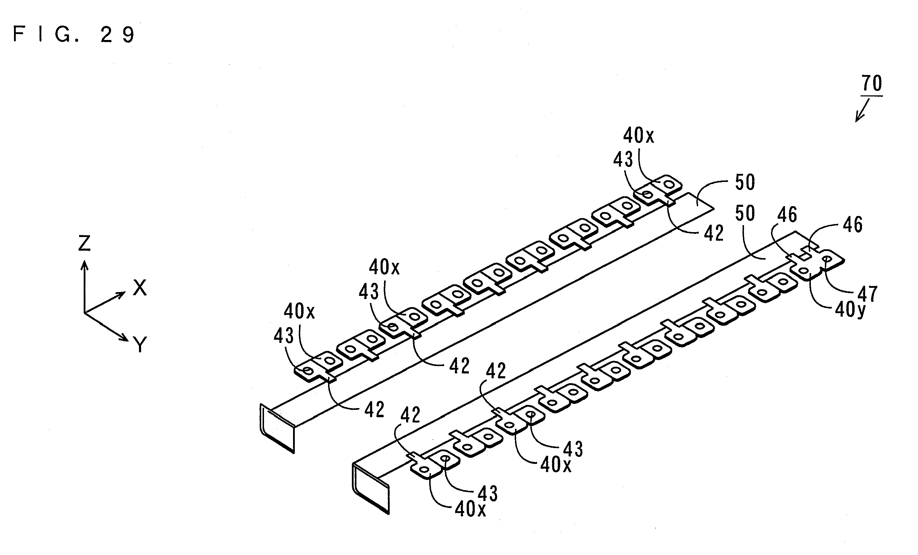

In the battery module 100 according to the above-mentioned embodiment, the FPC board 50 as well as the plurality of voltage bus bars 40x and the voltage/current bus bar 40y, which are arranged on the upper surface of the battery block 10B, constitute a wiring member 70 illustrated in Fig. 29, described below. The wiring member 70 connects the plus electrode 10a or the minus electrode 10b of each of the battery cells 10 and the detection circuit 20.

In the present embodiment, the plus electrodes 10a or the minus electrodes 10b of the plurality of battery cells 10 and the detection circuit 20 are respectively connected to each other by the plurality of conductor lines 51. The minus electrode 10b of the battery cell 10 at the one end and the amplification circuit 410 are connected to each other via the conductor line 52. The wiring member 70 is a member for integrating the plurality of conductor lines 52 and the conductor line 51.

In the present embodiment, the voltage/current bus bar 40y constituting the wiring member 70 is laser-welded to the minus electrode 10b of the battery cell 10 at the one end, similarly to the voltage bus bar 40x. Thus, the shunt resistor RS is attached to the upper surface of the battery block 10B without protruding from the battery block 10B and while keeping the flatness of the battery block 10B.

When the voltage/current bus bar 40y and the voltage bus bar 40x are attached to the plus electrode 10a or the minus electrode 10b of each of the battery cells 10 with screws, an insulating partition wall is required to prevent a screwing tool from erroneously contacting adjacent screws. In this case, the screw and the partition wall are arranged on the upper surface of the battery block 10B. Therefore, the size in the height direction of the battery module 100 is increased. On the other hand, in the battery module 100 according to the above-mentioned embodiment, the screw and the partition wall need not be arranged on the upper surface of the battery block 10B. Thus, the size in the height direction of the battery module 100 can be reduced.

The shunt resistor RS is thus attached on the upper surface of the battery block 10B while the voltage/current bus bar 40y including the shunt resistor RS is welded to the minus electrode 10b of the battery cell 10 at the one end, similarly to the other voltage bus bar 40x. Thus, the height of the battery module 100 can be made smaller than that when the voltage bus bar 40x and the voltage/current bus bar 40y are attached to the plus electrode 10a or the minus electrode 10b of the battery cell 10 with screws.

### (8) Modified Example in First Embodiment

(a) While an example in which the plus electrode 10a of the battery cell 10 is formed of aluminum has been described in the first embodiment, the present invention is not limited to this. The plus electrode 10a of the battery cell 10 may be formed of an aluminum alloy having a high strength and having a low resistivity, for example. In this case, the region 41a in the voltage bus bar 40x is preferably formed of the same aluminum alloy as the plus electrode 10a of the battery cell 10.

Similarly, while an example in which the minus electrode 10b of the battery cell 10 is formed of copper has been described, the present invention is not limited to this. The minus electrode 10b of the battery cell 10 may be formed of silver, gold, or an alloy of silver or gold having a high strength and having a low resistivity, for example. In this case, the region 41b in the voltage bus bar 40x and the conductive plate 59 in the FPC board 50 are preferably formed of silver, gold, or an alloy of silver or gold, similarly to the minus electrode 10b of the battery cell 10.

The voltage/current bus bar 40y may be formed of a copper alloy such as a copper-manganese alloy or a copper-nickel alloy, for example. Thus, a part of the voltage/current bus bar 40y can be easily used as the shunt resistor RS.

(b) While a part of the bus bar attached to the minus electrode 10b of the battery cell 10 at the one end is used as the shunt resistor RS in the battery module 100 according to the first embodiment, the present invention is not limited to this. A part of the bus bar attached to the plus electrode 10a of the battery cell 10 at the other end may be used as the shunt resistor RS.

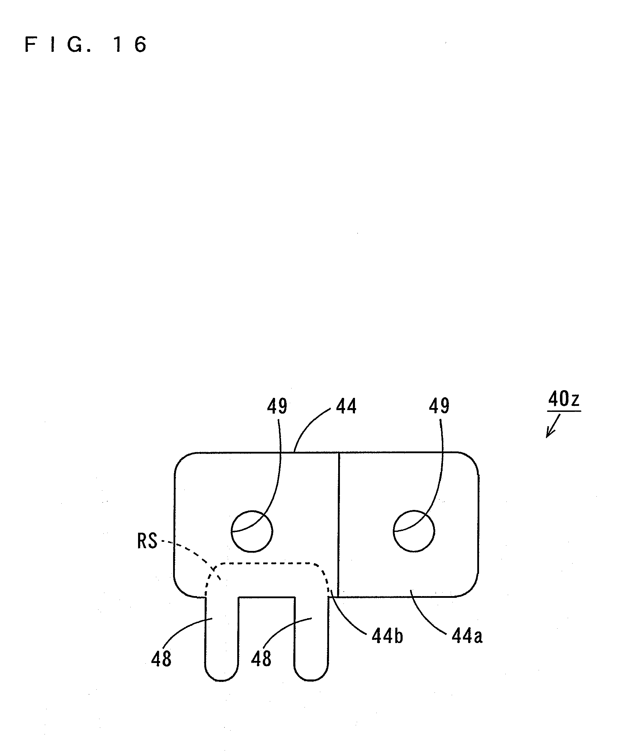

Fig. 16 is a plan view of a voltage/current bus bar 40z in another example. As illustrated in Fig. 16, the voltage/current bus bar 40z includes a base portion 44 having a substantially rectangular shape and attachment portions 48. The base portion 44 is formed of a clad material having two types of metals crimped to each other. The base portion 44 is divided into two regions 44a and 44b. The region 44a in the base portion 44 is formed of aluminum, and the region 44b in the base portion 44 is formed of copper.

The paired attachment portions 48 are formed to be spaced apart from each other and protrude from the long side of the region 44b in the base portion 44. Electrode connection holes 49 are respectively formed in the regions 44a and 44b in the base portion 44. In an example illustrated in Fig. 16, a region leading from the one attachment portion 48 in the voltage/current bus bar 40z to the other attachment portion 48 via the base portion 44 is used as a shunt resistor RS.

The electrode connection hole 49 formed in the region 44a in the voltage/current bus bar 40z is attached to the plus electrode 10a of the battery cell 10 at the other end (see Fig. 9). A screw S is threadably mounted on a screw hole formed in the other end surface frame 92 in the battery module 100 (see Fig. 9) through a through hole in a ring terminal 501t of a power supply line 501 and the electrode connection hole 49 in the region 44b in the voltage/current bus bar 40z. Thus, a current flowing through the battery module 100 is detected based on a voltage between both ends of the shunt resistor RS.

(c) While the voltage/current bus bar 40y attached to the minus electrode 10b of the battery cell 10 at the one end and the ring terminal 501t of the power supply line 501 are fixed to the one end surface frame 92 with the screw S in the first embodiment, the present invention is not limited to this. The one end surface frame 92 may be provided with an output terminal, and the voltage/current bus bar 40y attached to the minus electrode 10b of the battery cell 10 at the one end and an end of the power supply line 501 may be laser-welded, for example, to the output terminal.

Similarly, while the voltage bus bar 40x attached to the plus electrode 10a of the battery cell 10 at the other end and the ring terminal 501t of the power supply line 501 are fixed to the other end surface frame 92 with the screw S, the present invention is not limited to this. The other end surface frame 92 may be provided with an output terminal, and the voltage bus bar 40x attached to the plus electrode 10a of the battery cell 10 at the other end and an end of the power supply line 501 may be laser-welded, for example, to the output terminal.

(d) While the plus electrode 10a of the battery cell 10 and the region 41a in the voltage bus bar 40x are fixed to each other by laser welding in the first embodiment, the present invention is not limited to this. The plus electrode 10a of the battery cell 10 and the region 41a in the voltage bus bar 40x may be fixed to each other by another welding, caulking processing, a screw, or the like.

While the minus electrode 10b of the battery cell 10 and the region 41b in the voltage bus bar 40x are fixed to each other by laser welding, the present invention is not limited to this. The minus electrode 10b of the battery cell 10 and the region 41b in the voltage bus bar 40x may be fixed to each other by another welding, caulking processing, a screw, or the like.

Further, while the minus electrode 10b of the battery cell 10 at the one end and the voltage/current bus bar 40y are fixed to each other by laser welding, the present invention is not limited to this. The minus electrode 10b of the battery cell 10 at the one end and the voltage/current bus bar 40y may be fixed to each other by another welding, caulking processing, a screw, or the like.

(e) While the attachment portions 42 in the plurality of voltage bus bar 40x and the pair of attachment portions 46 in the voltage/current bus bar 40y are attached to the corresponding conductive plate 59 on the FPC board 50 by soldering in the first embodiment, the present invention is not limited to this. The attachment portions 42 in the plurality of voltage bus bars 40x and the pair of attachment portions 46 in the voltage/current bus bar 40y may be attached to the corresponding conductive plate 59 on the FPC board 50 by welding.

(f) While the battery ECU 101 has the current calculation function for calculating the current value Is of the voltage/current bus bar 40y based on the voltage value Vs between both ends of the shunt resistor RS of the voltage/current bus bar 40y and the shunt resistance value Rs in the first embodiment, the present invention is not limited to this. The detection circuit 20 may have a current calculation function instead of the battery ECU 101.

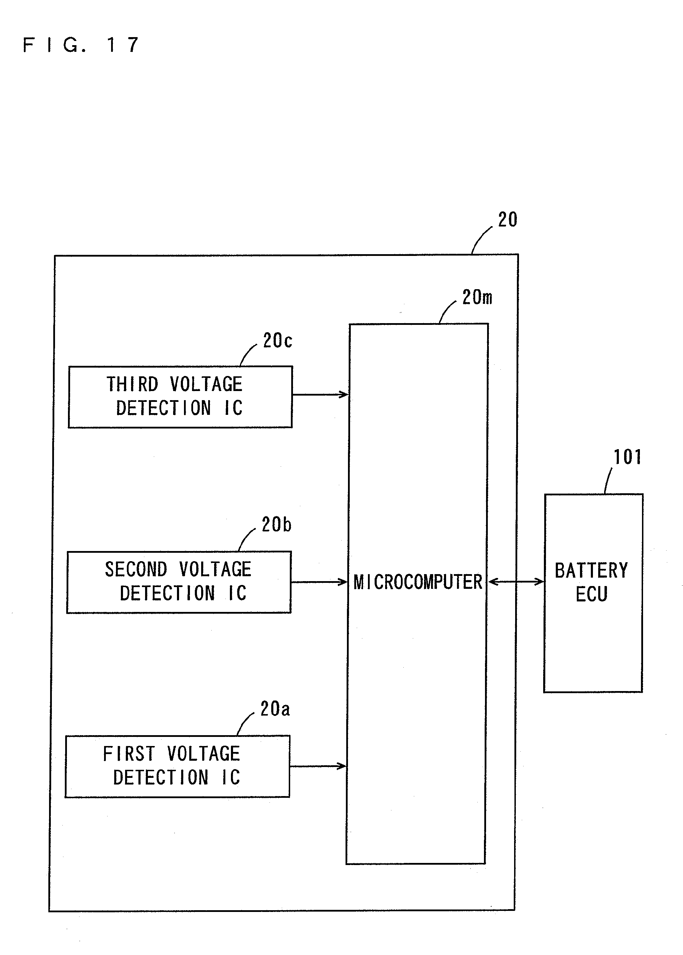

Fig. 17 illustrates an example of a configuration of a detection circuit 20 having the current calculation function. As illustrated in Fig. 17, the detection circuit 20 is provided with a microcomputer 20m, for example, in addition to the configuration illustrated in Fig. 13. The shunt resistance value Rs in the voltage/current bus bar 40y is previously stored in the microcomputer 20m in the detection circuit 20.

Thus, the microcomputer 20m in the detection circuit 20 may calculate a current value Is of the voltage/current bus bar 40y based on the voltage value Vs between both ends of the shunt resistor and the shunt resistance value Rs, which are output from the first voltage detection IC 20a illustrated in Fig. 13.

Further, in this case, the microcomputer 20m in the detection circuit 20 may calculate the voltage between the terminals of each of the battery cells 10 based on the outputs of the first to third voltage detection ICs 20a to 20c.

As described above, the calculated current value Is and the voltage between the terminals of each of the battery cells 10 are fed to the battery ECU 101.

In addition to the foregoing, the microcomputer 20m in the detection circuit 20 may calculate a charged capacity of each of the battery cells 10 based on the calculated current value Is, the calculated voltage between the terminals of the battery cell 10, and a temperature of the battery cell 10 to be detected by the thermistors 11 illustrated in Fig. 1.

In this case, the calculated current value Is, the calculated voltage between the terminals of the battery cell 10, the detected temperature of the battery cell 10, and the charged capacity of the battery cell 10 are given to the battery ECU 101 from the microcomputer 20m.

While an example in which the detection circuit 20 is provided with the microcomputer 20m in this example, the current calculation function may be implemented by providing a CPU and a memory instead of the microcomputer 20m.

The microcomputer 20m in this example or the CPU and the memory can be provided on the printed circuit board 21 illustrated in Fig. 4, for example.

(g) In the first embodiment, the region leading from the one attachment portion 46 in the voltage/current bus bar 40y to the other attachment portion 46 via the base portion 45 is used as the shunt resistor RS. Instead, the voltage/current bus bar 40y and its peripheral members may have the following configuration.

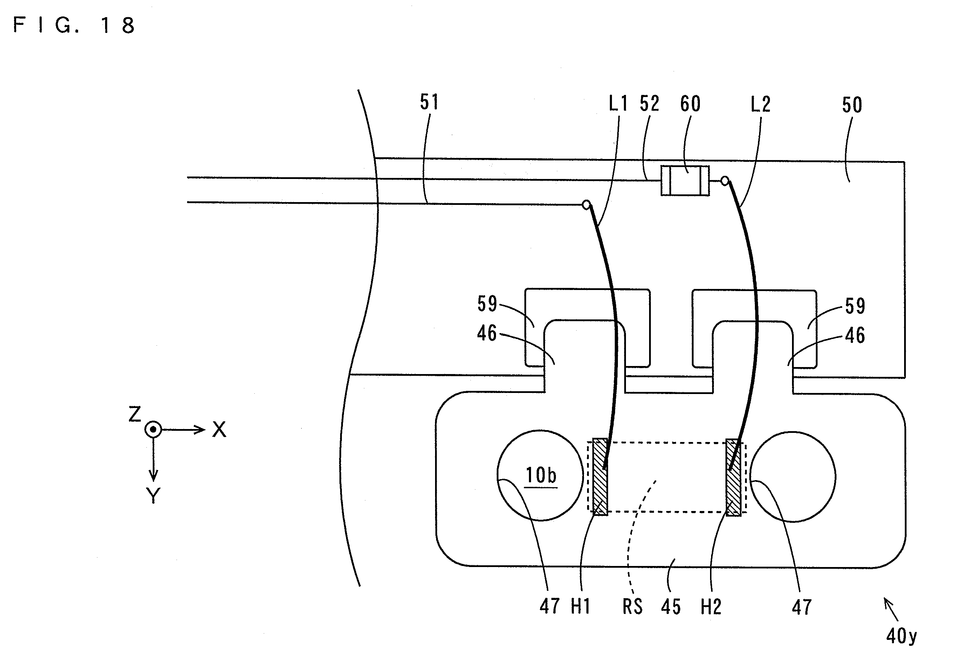

Fig. 18 is a schematic plan view illustrating a configuration of a voltage/current bus bar 40y and its peripheral members according to a modified example. A difference of the voltage/current bus bar 40y according to the modified example from the voltage/current bus bar 40y illustrated in Fig. 12 will be described.

As illustrated in Fig. 18, a pair of solder patterns H1 and H2 are formed at a predetermined spacing and parallel to each other on a base portion 45 in the voltage/current bus bar 40y. The solder pattern H1 is arranged between a pair of electrode connection holes 47 and in the vicinity of one of the electrode connection holes 47, and the solder pattern H2 is arranged between the electrode connection holes 47 and in the vicinity of the other electrode connection hole 47.

The solder pattern H1 on the voltage/current bus bar 40y is connected to a corresponding conductor line 51 on the detection circuit 20 (see Fig. 11) with a wire L1. A PTC element 60 is inserted into the conductor line 51. The solder pattern H2 on the voltage/current bus bar 40y is connected to a corresponding conductor line 52 on the detection circuit 20 with a wire L2. The PTC element 60 may be inserted into either one of the conductor lines 51 and 52. In an example illustrated in Fig. 18, the PTC element 60 is inserted into the conductor line 52.

In this example, a resistor formed between the solder patterns H1 and H2 on the voltage/current bus bar 40y is a shunt resistor RS for current detection. A shunt resistance value Rs is calculated based on the length, the cross section area, and the resistivity of a current path. Therefore, the solder patterns H1 and H2 are preferably formed so that a value of the shunt resistor RS in the voltage/current bus bar 40y can be accurately calculated.

When the battery cell 10 is charged/discharged, a current mainly flows in a region between the pair of electrode connection holes 47. The solder patterns H1 and H2 are preferably formed to be in close proximity to each of the electrode connection holes 47 and extend in a direction perpendicular to a straight line connecting the centers of the electrode connection holes 47. Further, both the lengths of the solder patterns H1 and H2 are preferably substantially equal to the diameter of the electrode connection hole 47.

The value of the shunt resistor RS may be previously calculated based on the lengths of the solder patterns H1 and H2, a distance between the solder patterns H1 and H2, the thickness of the base portion 45, and the resistivity of the base portion 45, and the calculated value may be stored in the memory within the battery ECU 101.

Alternatively, the value of the shunt resistor RS between the solder patterns H1 and H2 may be previously measured, and the measured value may be stored in the memory in the battery ECU 101.

Thus, in this example, a resistor between the solder patterns H1 and H2 formed in the voltage/current bus bar 40y is used as the shunt resistor RS. Therefore, the shunt resistance value Rs can be easily set to its optimum value by adjusting the dimensions of the solder patterns H1 and H2.

### [2] Second Embodiment

An electric vehicle according to a second embodiment will be described below. The electric vehicle according to the present embodiment includes the battery module 100 and the battery system 500 according to the first embodiment. An electric automobile will be described below as one example of the electric vehicle.

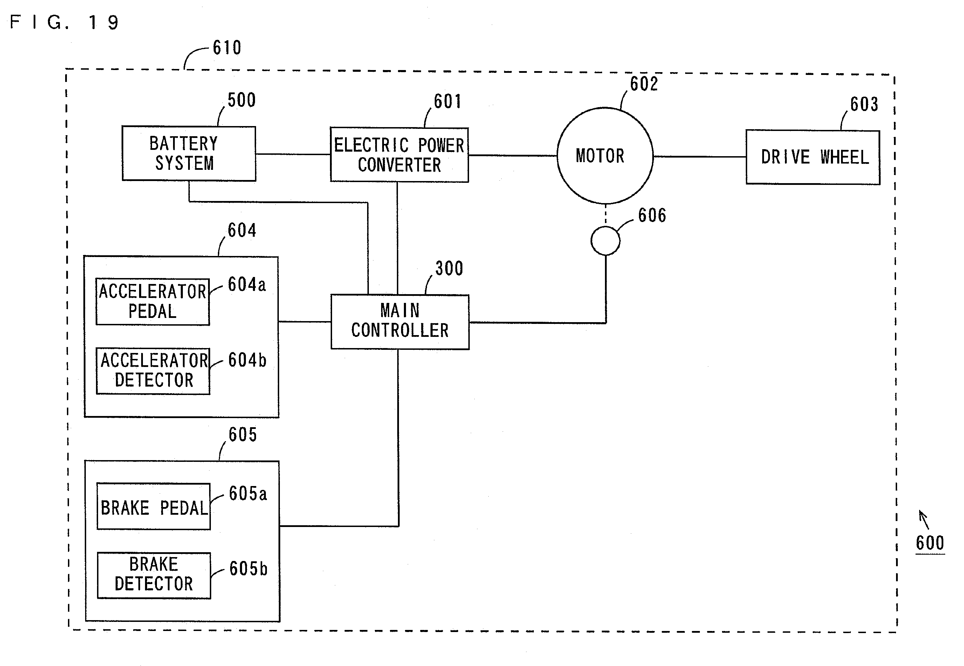

Fig. 19 is a block diagram illustrating a configuration of the electric automobile including the battery system 500 illustrated in Fig. 1. As illustrated in Fig. 19, an electric automobile 600 according to the present embodiment includes a vehicle body 610. The vehicle body 610 includes the main controller 300 and the battery system 500 illustrated in Fig. 1, an electric power converter 601, a motor 602, a drive wheel 603, an accelerator device 604, a brake device 605, and a rotational speed sensor 606. When the motor 602 is an alternating current (AC) motor, the electric power converter 601 includes an inverter circuit.

In the present embodiment, the battery system 500 is connected to the motor 602 via the electric power converter 601 while being connected to the main controller 300. As described above, charged capacities of a plurality of battery modules 100 (Fig. 1) and a value of a current flowing through the battery modules 100 are fed to the main controller 300 from the battery ECU 101 (Fig. 1) constituting the battery system 500. The accelerator device 604, the brake device 605, and the rotational speed sensor 606 are connected to the main controller 300. The main controller 300 is composed of a CPU (Central Processing Unit) and a memory or a microcomputer, for example.

The accelerator device 604 includes an accelerator pedal 604a included in the electric automobile 600 and an accelerator detector 604b that detects an operation amount (depression amount) of the accelerator pedal 604a. When a driver operates the accelerator pedal 604a, the accelerator detector 604b detects an operation amount of the accelerator pedal 604a using a state where the driver does not operate the accelerator pedal 604a as a basis. The detected operation amount of the accelerator pedal 604a is fed to the main controller 300.

The brake device 605 includes a brake pedal 605a included in the electric automobile 600 and a brake detector 605b that detects an operation amount (depression amount) of the brake pedal 605a by the driver. When the driver operates the brake pedal 605a, the brake detector 605b detects the operation amount. The detected operation amount of the brake pedal 605a is fed to the main controller 300.

The rotational speed sensor 606 detects a rotational speed of the motor 602. The detected rotational speed is given to the main controller 300.

As described above, the charged capacity of the battery module 100, the value of the current flowing through the battery module 100, the operation amount of the accelerator pedal 604a, the operation amount of the brake pedal 605a, and the rotational speed of the motor 602 are given to the main controller 300. The main controller 300 performs charge/discharge control of the battery modules 100 and electric power conversion control of the electric power converter 601 based on the information.

Electric power generated in the battery modules 100 is supplied from the battery system 500 to the electric power converter 601 at the time of start-up and acceleration of the electric automobile 600 based on an accelerator operation, for example.

Further, the main controller 300 calculates a torque (commanded torque) to be transmitted to the drive wheel 603 based on the given operation amount of the accelerator pedal 604a, and feeds a control signal based on the commanded torque to the electric power converter 601.

The electric power converter 601, which has received the above-mentioned control signal, converts the electric power supplied from the battery system 500 into electric power (driving electric power) required to drive the drive wheel 603. Thus, the driving electric power obtained in the conversion by the electric power converter 601 is supplied to the motor 602, and the torque generated by the motor 602 based on the driving electric power is transmitted to the drive wheel 603.

On the other hand, the motor 602 functions as a power generation apparatus at the time of deceleration of the electric automobile 600 based on a brake operation. In this case, the electric power converter 601 converts regenerated electric power generated by the motor 602 to electric power suited to charge the battery modules 100, and supplies the electric power to the battery modules 100. Thus, the battery modules 100 are charged.

As described above, the electric automobile 600 according to the present embodiment is provided with the battery system 500 according to the first embodiment. In the battery system 500, the current flowing through the battery module 100 is detected in a simple configuration. Thus, the electric automobile 600 can be controlled based on a value of the current flowing through the battery module 100.

While an example in which the battery module 100 (the battery system 500) is loaded into the electric vehicle has been described, the battery module 100 may be loaded into another movable body such as a ship, an airplane, or a walking robot.

The ship, which is loaded with the battery module 100, includes a hull instead of the vehicle body 610 illustrated in Fig. 19, includes a screw instead of the drive wheel 603, includes an accelerator inputter instead of the accelerator device 604, and includes a deceleration inputter instead of the brake device 605, for example. A driver operates the acceleration inputter instead of the accelerator device 604 in accelerating the hull, and operates the deceleration inputter instead of the brake device 605 in decelerating the hull. In this case, the motor 602 is driven with electric power from the battery module 100, and a torque generated by the motor 602 is transmitted to the screw to generate an impulsive force so that the hull moves.

Similarly, the airplane, which is loaded with the battery module 100, includes an airframe instead of the vehicle body 610 illustrated in Fig. 19, includes a propeller instead of the drive wheel 603, includes an acceleration inputter instead of the accelerator device 604, and includes a deceleration inputter instead of the brake device 605, for example. The walking robot, which is loaded with the battery module 100, includes a body instead of the vehicle body 610 illustrated in Fig. 19, includes a foot instead of the drive wheel 603, includes an acceleration inputter instead of the accelerator device 604, and includes a deceleration inputter instead of the brake device 605, for example.

Thus, in the movable body, which is loaded with the battery module 100, a power source (motor) converts the electric power from the battery module 100 into power, and the main movable body (the vehicle body, the hull, the airframe, or the body) moves with the power.

### [3] Third Embodiment

### (1) Power Supply Device

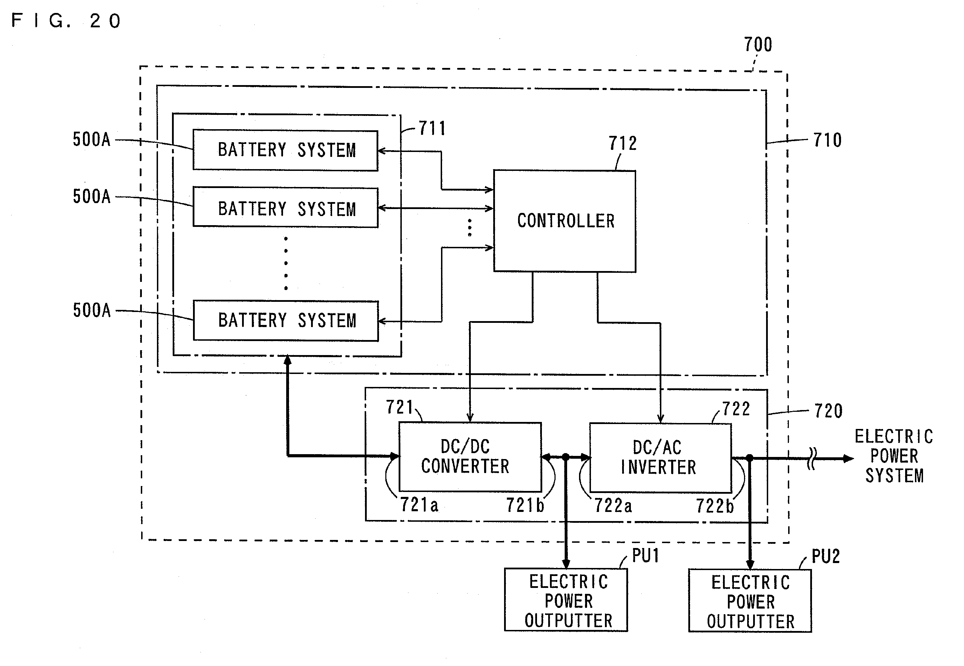

A power supply device according to a third embodiment will be described below. Fig. 20 is a block diagram illustrating a configuration of a power supply device according to the third embodiment.

As illustrated in Fig. 20, a power supply device 700 includes a power storage device 710 and a power conversion device 720. The power storage device 710 includes a battery system group 711 and a controller 712. The battery system group 711 includes a plurality of battery systems 500A. Each of the battery systems 500A includes a plurality of battery modules 100, which are connected in series, illustrated in Fig. 2. The plurality of battery systems 500A may be connected in parallel, or may be connected in series. Details of the battery system 500A will be described below.

The controller 712 includes a CPU and a memory, or a microcomputer, for example. The controller 712 is connected to a detection circuit 20 in each of the battery modules 100 (Fig. 2) included in each of the battery systems 500A. A value of a terminal voltage and a value of a temperature, which have been detected by the detection circuit 20 in each of the battery modules 100, are given to the controller 712. The detection circuit 20 gives a value of a voltage between both ends of a shunt resistor RS, which has been amplified by an amplification circuit 410 (Fig. 11), (hereinafter merely referred to as a voltage between both ends of the shunt resistor RS) to the controller 712.

The controller 712 calculates a value of a current flowing through the battery module 100 based on the voltage value between both ends of the shunt resistor RS. The controller 712 calculates a charged capacity of each of the battery cells 10 (Fig. 2) based on the value of the terminal voltage and the value of the temperature, which have been given from the detection circuit 20, and the calculated current value, and controls the power conversion device 720 based on the calculated charged capacity. Further, the controller 712 performs control, described below, as control relating to discharge or charge of the battery module 100 in the battery system 500.

The power conversion device 720 includes a DC/DC (direct current/direct current) converter 721 and a DC/AC (direct current/alternating current) inverter 722. The DC/DC converter 721 has input/output terminals 721a and 721b, and the DC/AC inverter 722 has input/output terminals 722a and 722b. The input/output terminal 721a of the DC/DC converter 721 is connected to the battery system group 711 in the power storage device 710. The input/output terminal 721b of the DC/DC converter 721 and the input/output terminal 722a of the DC/AC inverter 722 are connected to each other while being connected to an electric power outputter PU1. The input/output terminal 722b of the DC/AC inverter 722 is connected to an electric power outputter PU2 while being connected to another electric power system. Each of the electric power outputters PU1 and PU2 has an outlet, for example. Various loads, for example, are connected to the electric power outputters PU1 and PU2. The other electric power system includes a commercial power supply or a solar battery, for example. The electric power outputters PU1 and PU2 and the other electric power system are examples of an external object connected to the power supply device. If a solar battery is used as the electric power system, the solar battery is connected to the input/output terminal 721b of the DC/DC converter 721. On the other hand, if a solar power generation system including the solar battery as the electric power system is used, an AC outputter of a power conditioner in the solar power generation system is connected to the input/output terminal 722b of the DC/AC inverter 722.

The controller 712 controls the DC/DC converter 721 and the DC/AC inverter 722 so that the battery system group 711 is discharged and charged.

When the battery system group 711 is discharged, the DC/DC converter 721 performs DC/DC (direct current/direct current) conversion of electric power fed from the battery system group 711, and the DC/AC inverter 722 further performs DC/AC (direct current/alternating current) conversion thereof.

If the power supply device 700 is used as a DC power supply, electric power obtained in the DC/DC conversion by the DC/DC converter 721 is supplied to the electric power outputters PU1. If the power supply device 700 is used as an AC power supply, electric power obtained in the DC/AC conversion by the DC/AC inverter 722 is supplied to the electric power outputter PU2. AC electric power obtained in the conversion by the DC/AC inverter 722 can also be supplied to another electric power system.

When the battery system group 711 is discharged, the controller 712 determines whether the discharge of the battery system group 711 is stopped or not or whether a discharging current (or discharging electric power) is limited or not based on the calculated charged capacity, and controls the power conversion device 720 based on a determination result. More specifically, when the charged capacity of any one of the plurality of battery cells 10 (Fig. 2) included in the battery system group 711 becomes smaller than a predetermined threshold value, the controller 712 controls the DC/DC converter 721 and the DC/AC inverter 722 so that the discharge of the battery system group 711 is stopped or the discharging current (or discharging electric power) is limited. Thus, each of the battery cells 10 is prevented from being overdischarged. The controller 712 may determine whether the discharge of the battery system group 711 is stopped or not or whether the discharging current (or discharging electric power) is limited or not based on an instruction from an external object, to control the power conversion device 720 based on a determination result.

The discharging current (or discharging electric power) is limited so that a voltage of the battery system group 711 becomes a predetermined reference voltage. The controller 712 sets the reference voltage based on the charged capacity of the battery cell 10 or the instruction from the external object.

On the other hand, when the battery system group 711 is charged, the DC/AC inverter 722 performs AC/DC (alternating current/direct current) conversion of AC electric power fed from another electric power system, and the DC/DC converter 721 further performs DC/DC (direct current/direct current) conversion thereof. Electric power is fed from the DC/DC converter 721 to the battery system group 711 so that the plurality of battery cells 10 (Fig. 2) included in the battery system group 711 are charged.

When the battery system group 711 is charged, the controller 712 determines whether the charge of the battery system group 711 is stopped or not or whether a charging current (or charging electric power) is limited or not based on the calculated charged capacity, and controls the power conversion device 720 based on a determination result. More specifically, when the charged capacity of any one of the plurality of battery cells 10 (Fig. 2) included in the battery system group 711 becomes larger than a predetermined threshold value, the controller 712 controls the DC/DC converter 721 and the DC/AC inverter 722 so that the charge of the battery system group 711 is stopped or the charging current (or charging electric power) is limited. Thus, each of the battery cells 10 is prevented from being overcharged. The controller 712 may determine whether the charge of the battery system group 711 is stopped or not or whether the charging current (or charging electric power) is limited or not based on an instruction from the external object, to control the power conversion device 720 based on a determination result.

The discharging current (or discharging electric power) is limited so that a voltage of the battery system group 711 becomes a predetermined reference voltage. The controller 712 sets the reference voltage based on the charged capacity of the battery cell 10 or the instruction from the external object.

If electric power can be supplied between the power supply device 700 and the external object, the power conversion device 720 may include only either one of the DC/DC converter 721 and the DC/AC inverter 722. If electric power can be supplied between the power supply device 700 and the external object, the power conversion device 720 need not be provided.

### (2) Battery System

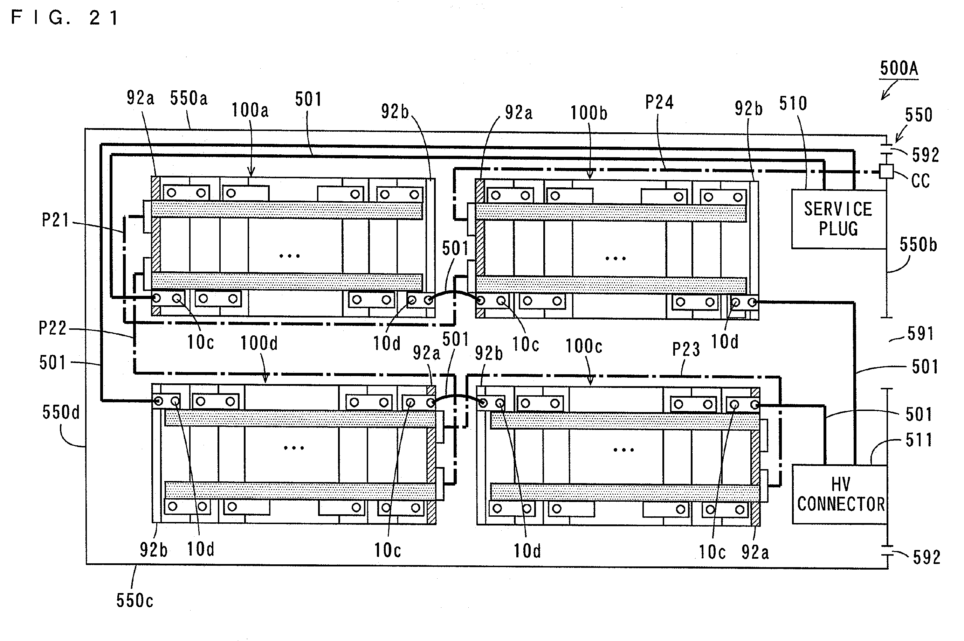

Fig. 21 is a schematic plan view illustrating a configuration of the battery system 500A in the power supply device 700. As illustrated in Fig. 21, the battery system 500A includes four battery modules 100, a service plug 510, and an HV connector 511. In the following description, the four battery modules 100 in the battery system 500A are respectively referred to as battery modules 100a, 100b, 100c, and 100d. Out of a pair of end surface frames 92 provided in each of the battery modules 100a to 100d, the end surface frame 92 to which the printed circuit board 21 (Fig. 2) is attached is referred to as an end surface frame 92a, and the end surface frame 92 to which the printed circuit board 21 is not attached is referred to as an end surface frame 92b. In Fig. 21, the end surface frame 92a is hatched.

The battery modules 100a to 100d, the service plug 510, and the HV connector 511 are housed in a box-shaped housing 550. The housing 550 has side surface portions 550a, 550b, 550c, and 550d. The side surface portions 550a and 550c are parallel to each other, and the side surface portions 550b and 550d are parallel to each other and are perpendicular to the side surface portions 550a and 550c.

In the housing 550, the battery modules 100a and 100b are arranged to line up at a predetermined spacing along a lamination direction of battery cells 10. The battery modules 100c and 100d are arranged to line up at a predetermined spacing along the lamination direction of the battery cells 10.

In the housing 550, the battery modules 100a and 100b are arranged along and in close proximity to the side surface portion 550a, and the battery modules 100c and 100d are arranged in parallel with the battery modules 100a and 100b. The end surface frame 92a of each of the battery modules 100a and 100b is directed toward the side surface portion 550d. The end surface frame 92a of each of the battery modules 100c and 100d is directed toward the side surface portion 550b.

The service plug 510 is provided in the side surface portion 550b in the housing 550 to be adjacent to the battery module 100b. The HV connector 511 is provided in the side surface portion 550b in the housing 550 to be adjacent to the battery module 100c.

In each of the battery modules 100a to 100d, a potential of the plus electrode 10a (Fig. 3) of the battery cell 10 (the first battery cell 10) adjacent to the end surface frame 92a is the highest, and a potential of the minus electrode 10b (Fig. 3) of the battery cell 10 (the eighteenth battery cell 10) adjacent to the end surface frame 92b is the lowest. In each of the battery modules 100a to 100d, the plus electrode 10a (Fig. 3) having the highest potential is referred to as a high-potential electrode 10c, and the minus electrode 10b (Fig. 3) having the lowest potential is referred to as a low-potential electrode 10d.

The low potential electrode 10d of the battery module 100a and the high potential electrode 10c of the battery module 100b are connected to each other via a power supply line 501. The low potential electrode 10d of the battery module 100c and the high potential electrode 10c of the battery module 100d are connected to each other via a power supply line 501.

The high potential electrode 10c of the battery module 100a is connected to the service plug 510 via a power supply line 501, and the low potential electrode 10d of the battery module 100d is connected to the service plug 510 via a power supply line 501. The battery modules 100a to 100d are connected in series with the service plug 510 turned on. In this case, a potential of the high potential electrode 10c of the battery module 100c is the highest, and a potential of the low potential electrode 10d of the battery module 100b is the lowest.

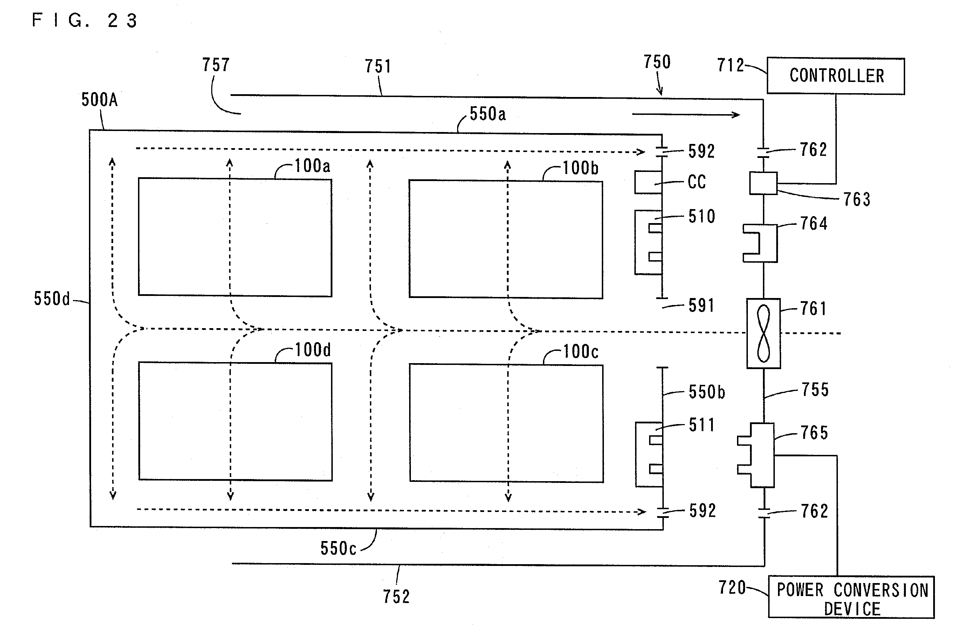

The service plug 510 is turned on by being connected to an ON/OFF switcher 764, described below (Fig. 23, described below). The service plug 510 is turned off in a state where it is not connected to the ON/OFF switcher 764. The service plug 510 is turned off by a worker at the time of maintenance of the battery system 500A, for example. If the service plug 510 is turned off, a series circuit of the battery modules 100a and 100b and a series circuit of the battery modules 100c and 100d are electrically separated from each other. In this case, a current path among the plurality of battery modules 100a to 100d is shut off. Thus, safety at the time of maintenance is ensured.

The low potential electrode 10d of the battery module 100b is connected to the HV connector 511 via a power supply line 501, and the high potential electrode 10c of the battery module 100c is connected to the HV connector 511 via a power supply line 501. The HV connector 511 is connected to the input/output terminal 721a of the DC/DC converter 721 (Fig. 20).

The printed circuit board 21 (Fig. 2) in the battery module 100a and the printed circuit board 21 in the battery module 100b are connected to each other via a communication line P21. The printed circuit board 21 in the battery module 100a and the printed circuit board 21 in the battery module 100d are connected to each other via a communication line P22. The printed circuit board 21 in the battery module 100c and the printed circuit board 21 in the battery module 100d are connected to each other via a communication line P23.

A communication connector CC for connection with the controller 712 illustrated in Fig. 20 is provided in the side surface portion 550b in the housing 550. The printed circuit board 21 in the battery module 100b is connected to the communication connector CC via a communication line P24.

In the side surface portion 550b in the housing 550, a ventilation port 591 is formed on an extension of a ventilation path between a row of the battery modules 100a and 100b and a row of the battery modules 100c and 100d. Ventilation ports 592 are respectively formed at a position of the side surface portion 550b in close proximity to the side surface portion 550a and a position of the side surface portion 550b in close proximity to the side surface portion 550c.

### (3) Installation of Battery System

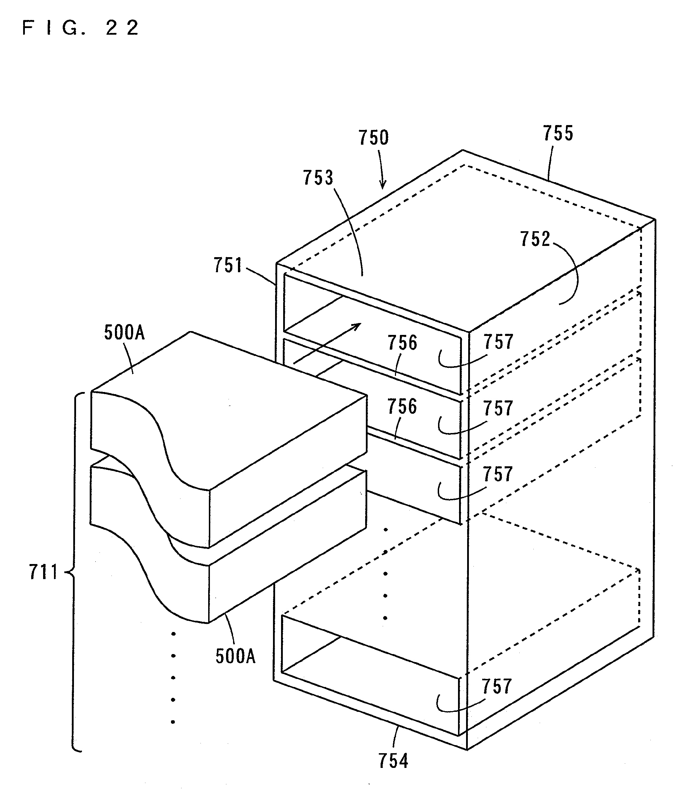

In the present embodiment, the plurality of battery systems 500A illustrated in Fig. 21 are housed in a common rack. Fig. 22 is a perspective view of the rack that houses the plurality of battery systems 500A.

As illustrated in Fig. 22, a rack 750 includes side surface portions 751 and 752, an upper surface portion 753, a bottom surface portion 754, a back surface portion 755, and a plurality of partition portions 756. The side surface portions 751 and 752 vertically extend parallel to each other. The upper surface portion 753 horizontally extends to connect upper ends of the side surface portions 751 and 752, and the bottom surface portion 754 horizontally extends to connect lower ends of the side surface portions 751 and 752. The back surface portion 755 vertically extends perpendicularly to the side surface portions 751 and 752 along one side of the side surface portion 751 and one side of the side surface portion 752. The plurality of partition portions 756 are equally spaced apart from one another parallel to the upper surface portion 753 and the bottom surface portion 754 between the upper surface portion 753 and the bottom surface portion 754.

A plurality of housing spaces 757 are provided among the upper surface portion 753, the plurality of partition portions 756, and the bottom surface portion 754. Each of the housing spaces 757 opens toward a front surface of the rack 750 (a surface opposite to the back surface portion 755). The battery system 500A illustrated in Fig. 21 is housed in each of the housing spaces 757 from the front surface of the rack 750.

Fig. 23 is a schematic plan view illustrating a state where the battery system 500A illustrated in Fig. 21 is housed in the housing space 757 in the rack 750 illustrated in Fig. 22. As illustrated in Fig. 23, the battery system 500A is housed in the housing space 757 in the rack 750 so that a side surface portion 550b in the battery system 500A is opposed to the back surface portion 755 in the rack 750.

In the back surface portion 755 in the rack 750, a cooling fin 761, two ventilation ports 762, a communication connector 763, an ON/OFF switcher 764, and an electric power connector 765 are provided for each of the housing spaces 757. The cooling fin 761 is provided at a position that overlaps a ventilation port 591 in the battery system 500A. The ventilation port 762 is provided at a position that overlaps a ventilation port 592 in the battery system 500A. The communication connector 763 is provided at a position that overlaps a communication connector CC in the battery system 500A. The ON/OFF switcher 764 is provided at a position that overlaps a service plug 510 in the battery system 500A. The power connector 765 is provided at a position that overlaps an HV connector 511 in the battery system 500A. The communication connector 763 is electrically connected to a controller 712. The power connector 765 is electrically connected to a power conversion device 720.

The battery system 500A is housed in the housing space 757 in the rack 750 so that the communication connector CC in the battery system 500A and the communication connector 763 in the rack 750 are connected to each other. As illustrated in Fig. 21, the printed circuit boards 21 on the end plates 92a in the battery modules 100a to 100d are respectively connected to the communication connector CC via the communication lines P21 to P24. Therefore, the communication connector CC in the battery system 500A and the communication connector 763 in the rack 750 are connected to each other so that the printed circuit boards 21 in the battery modules 100a to 100d and the controller 712 are connected to each other to be communicable.

The service plug 510 in the battery system 500A and the ON/OFF switcher 764 in the rack 750 are connected to each other. Thus, the service plug 510 is turned on. As a result, the battery modules 100a to 100d in the battery system 500A are connected in series.

Further, the HV connector 511 in the battery system 500A is connected to the power connector 765 in the rack 750. Thus, the HV connector 511 is connected to the power conversion device 720. As a result, electric power is supplied among the battery modules 100a to 100d in the battery system 500A.

Thus, the battery system 500A is housed in the housing space 757 in the rack 750 so that the service plug 510 is turned on while the HV connector 511 is connected to the power conversion device 720. On the other hand, with the battery system 500A not housed in the housing space 757 in the rack 750, the service plug 510 is turned off while the HV connector 511 is not connected to the power conversion device 720. Thus, with the battery system 500A not housed in the housing space 757 in the rack 750, a current path between the battery modules 100a to 100d is reliably blocked. Therefore, the battery system 500A can be subjected to maintenance work easily and safely.

With the battery system 500A housed in the housing space 757 in the rack 750, the cooling fin 761 introduces cooling gas into the housing 550 through the ventilation port 591. Thus, heat generated by each of the battery cells 10 (Fig. 2) in each of the battery modules 100a to 100d is absorbed by the cooling gas within the housing 550. The cooling gas, which has absorbed heat within the housing 550, is emitted through the ventilation ports 592 in the housing 550 and the ventilation ports 762 in the rack 750. Thus, the battery cell 10 in each of the battery modules 100a to 100d is cooled.

In this case, the rack 750 is provided with the cooling fin 761 so that a cooling fin need not be provided for each of the battery systems 500A. Thus, the cost of the battery system 500A is reduced. If cooling gas can be introduced into the housing 550 in each of the battery systems 500A, the battery system 500A may be provided with a cooling fin.

The cooling fin 761 may cause the cooling gas within the housing 550 to be emitted through the ventilation port 591. In this case, the cooling gas, which has been introduced into the housing 550 through the ventilation ports 762 and 592, absorbs heat within the housing 550, and is then emitted through the ventilation port 591. A ventilation port may be provided in each of side surface portions 550a and 550c in the housing 550 and side surface portions 751 and 752 in the rack in the battery system 500A. In this case, the emission of the cooling gas from inside the housing 550 and the introduction of the cooling gas into the housing 550 can be more efficiently performed.

While all the battery systems 500A are housed in one rack 750 in this example, all the battery systems 500A may be separately housed in a plurality of racks 750. The battery systems 500A may be individually installed to be connected to the controller 712 and the power conversion device 720.

### (4) Effects

In the power supply device 700 according to the present embodiment, the controller 712 controls the supply of electric power between the battery system group 711 and the external object. Thus, each of the battery cells 10 included in the battery system group 711 is prevented from being overdischarged and overcharged.

The battery system 500A in the power supply device 700 according to the present embodiment is provided with the battery module 100 according to the first embodiment. In this case, a part of the voltage/current bus bar 40y attached to the minus electrode 10b of the battery cell 10 at its one end is used as a shunt resistor RS for current detection. Therefore, the shape and the dimensions of the shunt resistor RS are not limited by a spacing between the adjacent battery cells 10. Thus, the shunt resistor RS can be easily set to its optimum value. The battery module 100 need not be separately provided with a shunt resistor. As a result, a current flowing through the battery module 100 can be detected in a simple configuration without increasing the size of the battery module 100.

### [4] Another Embodiment

(1) While all the battery modules 100 included in each of the battery systems 500 and 500A respectively have the shunt resistors RS in the above-mentioned embodiments, the present invention is not limited to this. At least one of the battery modules 100 included in each of the battery systems 500 and 500A may have a shunt resistor RS, and the other battery module 100 need not have a shunt resistor RS.

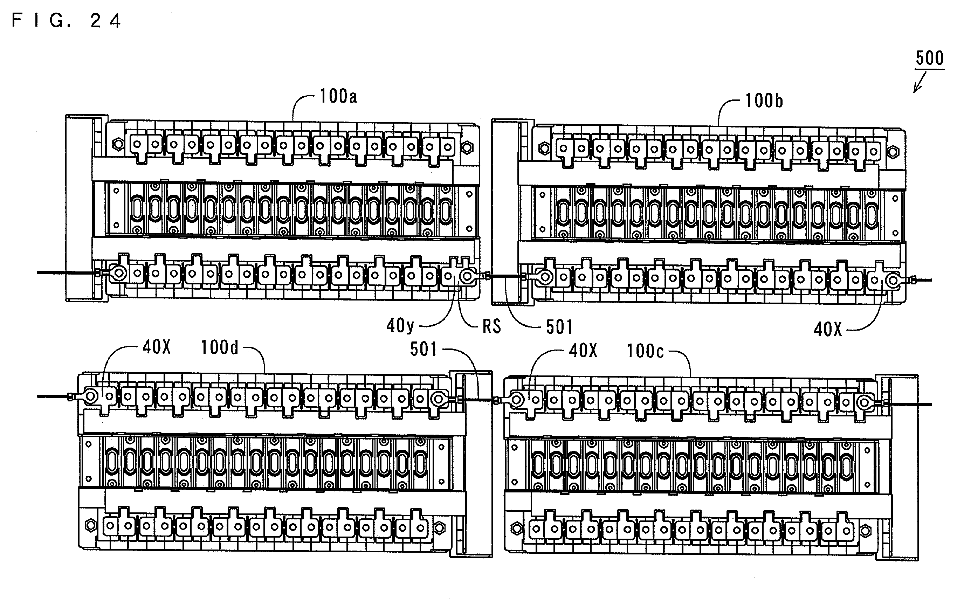

Fig. 24 is a plan view illustrating another example of the battery module 100 in the battery system 500. In Fig. 24, the illustration of the battery ECU 101 (Fig. 1), the contactor 102 (Fig. 1), the service plug 510 (Fig. 21), the HV connector 511 (Fig. 21), and the casing 550 (Fig. 21) is not repeated.

As illustrated in Fig. 24, four battery modules 100a to 100d are connected in series via a power supply line 501. In this case, at least one of the battery modules 100a to 100d has a voltage/current bus bar 40y. In Fig. 24, the voltage/current bus bar 40y having a shunt resistor RS is attached to the battery module 100a. A voltage bus bar 40X is attached instead of the voltage/current bus bar 40y to the battery modules 100b to 100d.

The voltage bus bar 40X has a similar configuration to that of the voltage bus bar 40x illustrated in Fig. 5 (a) except that a base portion 41 is not formed of a clad material including aluminum and copper but formed of copper. The shunt resistor RS is not formed in the voltage bus bar 40X.

The detection circuit 20 (Fig. 2) in the battery module 100a gives a value of a voltage between both ends of the shunt resistor RS to the battery ECU 101 (Fig. 1) or the controller 712 (Fig. 20). The battery ECU 101 or the controller 712 calculates a value of a current flowing through the battery modules 100a to 100d based on the voltage value given by the detection circuit 20 in the battery module 100a. The detection circuit 20 in each of the battery modules 100a to 100d can acquire the current value calculated by the battery ECU 101 or the controller 712, as needed.

Even when the battery modules 100b to 100d do not respectively have shunt resistors RS, the battery modules 100a to 100d can thus acquire the current value. Since the battery modules 100b to 100d do not respectively have shunt resistors RS, power consumption and heat generation in the shunt resistor RS can be prevented.

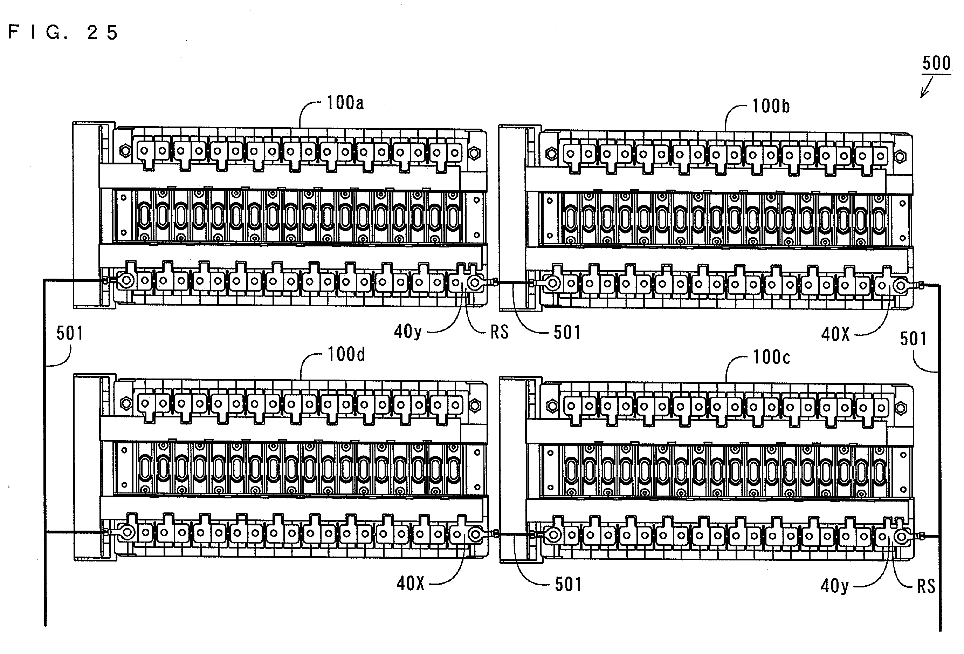

(2) Fig. 25 is a plan view illustrating still another example of the battery module 100 in the battery system 500. In Fig. 25, the illustration of the battery ECU 101 (Fig. 1), the contactor 102 (Fig. 1), the service plug 510 (Fig. 21), the HV connector 511 (Fig. 21), and the casing 550 (Fig. 21) is not repeated.

As illustrated in Fig. 25, the battery modules 100a and 100b are connected in series via a power supply line 501. The battery modules 100c and 100d are connected in series via a power supply line 501. A series circuit of the battery modules 100a and 100b and a series circuit of the battery modules 100c and 100d are connected in parallel via power supply lines 501, respectively.

In this case, at least one of the battery modules 100a and 100b included in one of the series circuits has a voltage/current bus bar 40y. At least one of the battery modules 100c and 100d included in the other series circuit has a voltage/current bus bar 40y. In Fig. 25, the voltage/current bus bar 40y having a shunt resistor RS is attached to the battery modules 100a and 100c. A voltage bus bar 40X is attached instead of the voltage/current bus bar 40y to each of the battery modules 100b and 100d.

The detection circuit 20 (Fig. 2) in the battery module 100a gives a value of a voltage between both ends of the shunt resistor RS to the battery ECU 101 (Fig. 1) or the controller 712 (Fig. 20). The battery ECU 101 or the controller 712 calculates a value of a current flowing through the battery modules 100a and 100b based on the voltage value given by the detection circuit 20 in the battery module 100a. The detection circuit 20 in each of the battery modules 100a and 100b can acquire the current value calculated by the battery ECU 101 or the controller 712, as needed.

Similarly, the detection circuit 20 (Fig. 2) in the battery module 100c gives a value of a voltage between both ends of the shunt resistor RS to the battery ECU 101 (Fig. 1) or the controller 712 (Fig. 20). The battery ECU 101 or the controller 712 calculates a value of a current flowing through the battery modules 100c and 100d based on the voltage value given by the detection circuit 20 in the battery module 100c. The detection circuit 20 in each of the battery modules 100c and 100d can acquire the current value calculated by the battery ECU 101 or the controller 712, as needed.

Even when the battery modules 100b and 100d do not respectively have shunt resistors RS, the battery modules 100a to 100d can thus acquire the current value. Since the battery modules 100b and 100d do not respectively have shunt resistors RS, power consumption and heat generation in the shunt resistor RS can be prevented.

(3) In the battery system group 711 illustrated in Fig. 20, when the plurality of battery systems 500A are connected in series, at least one of battery modules 100 in at least one of the battery systems 500A has a shunt resistor RS, and a plurality of battery modules 100 in the other battery system 500A need not have a shunt resistor RS.

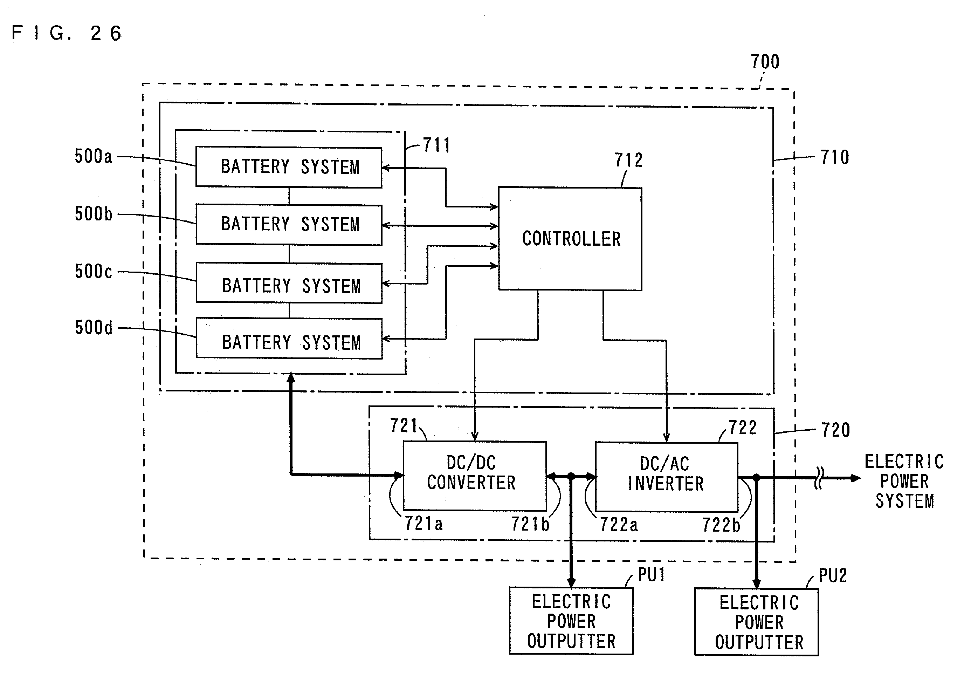

Fig. 26 is a schematic plan view illustrating another configuration of a battery system 500A in the power supply device 700. As illustrated in Fig. 26, four battery systems 500A are connected in series. In the following description, the four battery systems 500A in the power supply device 700 are respectively referred to as battery systems 500a, 500b, 500c, and 500d. In each of the battery systems 500a to 500d, four battery modules 100a to 100d (Fig. 21) are connected in series.

In this case, at least one of the battery modules 100a to 100d included in at least one of the battery systems 500a to 500d may have a voltage/current bus bar 40y. In Fig. 26, the voltage/current bus bar 40y having a shunt resistor RS is attached to the battery module 100a in the battery system 500a, like in the battery system 500 illustrated in Fig. 24.

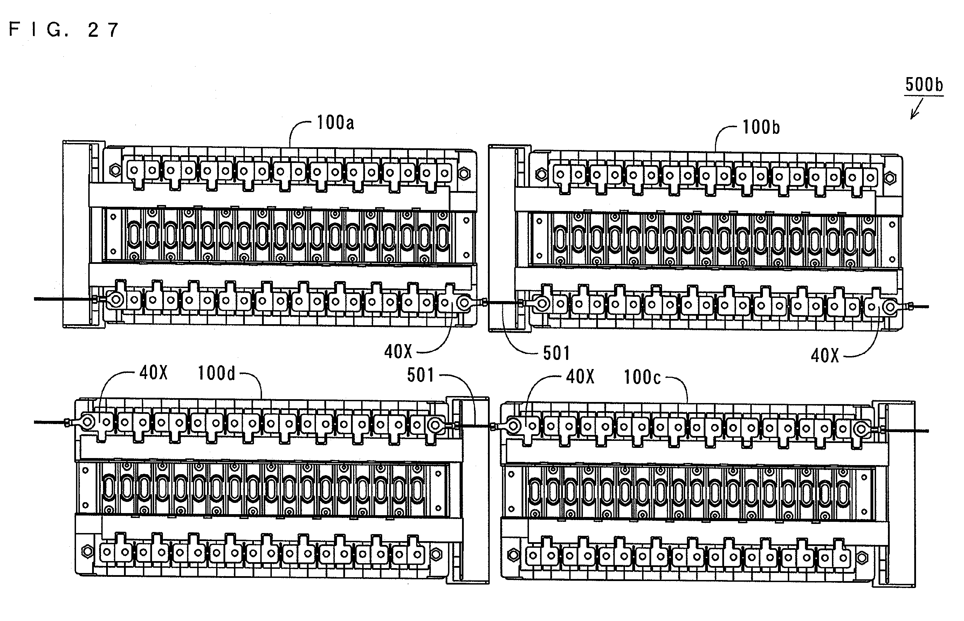

Fig. 27 is a schematic plan view illustrating a configuration of a battery system 500b in another configuration of the power supply device 700. In Fig. 27, the illustration of the service plug 510 (Fig. 21), the HV connector 511 (Fig. 21), and the casing 550 (Fig. 21) is not repeated. Battery systems 500c and 500d respectively have similar configurations to that of the battery system 500b. In each of the battery systems 500b to 500d, a voltage bus bar 40X is attached instead of a voltage/current bus bar 40y to each of battery modules 100a to 100d.

A detection circuit 20 (Fig. 2) in the battery module 100a in the battery system 500a gives a value of a voltage between both ends of a shunt resistor RS to a controller 712. The controller 712 calculates a value of a current flowing through the battery systems 500a to 500d based on the voltage value given by the detection circuit 20 in the battery module 100a in the battery system 500a. A detection circuit 20 in each of the battery modules 100a to 100d in each of the battery systems 500a to 500d can acquire the current value calculated by the controller 712, as needed.

Even when the battery modules 100a to 100d in the battery systems 500b to 500d do not respectively have shunt resistors RS, the battery modules 100a to 100d in the battery systems 500a to 500d can thus acquire the current value. Since the battery modules 100a to 100d in the battery systems 500b to 500d do not respectively have shunt resistors RS, power consumption and heat generation in the shunt resistor RS can be prevented.

(4) While the plurality of battery cells 10 are connected in series, to constitute the battery block 10B in the above-mentioned embodiment, the present invention is not limited to this.

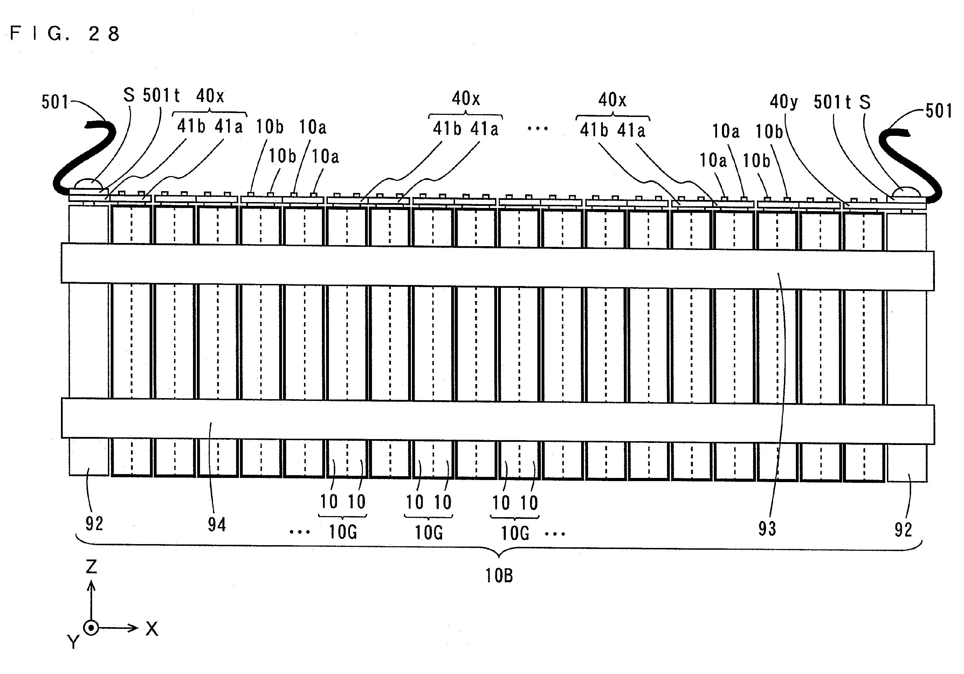

Fig. 28 is a side view illustrating another configuration of a battery block 10B. As illustrated in Fig. 28, a plurality of (two in an example illustrated in Fig. 28) battery cells 10 are connected in parallel, to constitute one parallel cell group 10G. The battery block 10B includes a plurality of parallel cell groups 10G. The plurality of parallel cell groups 10G are laminated in an X-direction. In this state, the parallel cell groups 10G are arranged so that a positional relationship between a set of plus electrodes 10a and a set of minus electrode 10b in a Y-direction in each of the parallel cell groups 10G is opposite to that in the adjacent parallel cell group 10G.

Thus, between the respective adjacent two parallel cell groups 10G, the set of plus electrodes 10a in one of the parallel cell groups 10G and the set of minus electrodes 10b in the other parallel cell group 10G are in close proximity to each other, and the set of minus electrodes 10b in one of the parallel cell groups 10G and the set of plus electrodes 10a in the other parallel cell group 10G are in close proximity to each other. In this state, a voltage bus bar 40x is attached to the set of plus electrodes 10a and the set of minus electrodes 10b in close proximity to each other. Thus, the plurality of parallel cell groups 10G are connected in series.

A voltage/current bus bar 40y for connecting a power supply line 501 from an external object is attached to the set of minus electrodes 10b in the parallel cell group 10G at one end. A voltage bus bar 40x for connecting a power supply line 501 from an external object is attached to the set of plus electrode 10a in the parallel cell group 10G at the other end.

In the voltage bus bar 40x illustrated in Fig. 28, two electrode connection holes 43 (Fig. 5) corresponding to the set of plus electrodes 10a are formed in a region 41a in a base portion 41 (Fig. 5). Two electrode connection holes 43 corresponding to the set of minus electrodes 10b are formed in a region 41b in the base portion 41. Similarly, in the voltage/current bus bar 40y illustrated in Fig. 28, two electrode connection holes 47 (Fig. 5) corresponding to the set of minus electrodes 10b are formed in a base portion 45 (Fig. 5).

A pair of end surface frames 92 integrally fixes a battery block 10B including the plurality of parallel cell groups 10G connected in series. Thus, the battery block 10B including the plurality of parallel cell groups 10G is configured. In the battery block 10B, each of the parallel cell groups 10G includes the plurality of battery cells 10 connected in parallel. Thus, the effective capacity of the battery cell 10 can be increased.

### (5) Another Procedure for Manufacturing Battery Module

Fig. 29 is an external perspective view illustrating a state where a plurality of voltage bus bars 40x and a voltage/current bus bar 40y are attached to FPC boards 50. As illustrated in Fig. 29, attachment portions 42 in the plurality of bas bars 40x and attachment portions 46 in the voltage/current bus bar 40y are attached at a predetermined spacing along an alignment direction (X-direction) of a plurality of battery cells 10 (Fig. 2) to the two FPC boards 50. Thus, a member obtained by integrally connecting the FPC boards 50, the plurality of voltage bus bars 40x, and the voltage/current bus bar 40y is hereinafter referred to as a wiring member 70. In the present embodiment, two wiring members 70 are used.

When the battery module 100 is manufactured, the wiring member 70 is attached on a battery block 10B (Fig. 2). At the time of this attachment, a plus electrode 10a and a minus electrode 10b of the adjacent battery cells 10, other than a plus electrode 10a of the battery cell 10 positioned at one end and a minus electrode 10b of the battery cell 10 positioned at the other end, are respectively fitted in electrode connection holes 43 in a voltage bus bar 40x. The plus electrode 10a of the battery cell 10 positioned at the one end is fitted in the electrode connection hole 43 in the voltage bus bar 40x. The minus electrode 10b of the battery cell 10 positioned at the other end is fitted in the electrode connection hole 47 in the voltage/current bus bar 40y.

In this state, the plus electrodes 10a and the minus electrodes 10b of the battery cells 10, excluding the minus electrode 10b of the battery cell 10 positioned at the other end, are respectively laser-welded to regions 41a and regions 41b in the voltage bus bars 40x. The minus electrode 10b of the battery cell 10 positioned at the other end is laser-welded to the voltage/current bus bar 40y. Thus, the plurality of battery cells 10, the plurality of voltage bus bars 40x, and the voltage/current bus bar 40y are fixed.

Thus, the wiring members 70 are attached to the battery block 10B while the FPC boards 50 in the wiring members 70 are held in a substantially horizontal posture on an upper surface of the battery block 10B. The battery module 100 can be easily assembled by attaching the wiring members 70 to the battery block 10B.

Each of the two wiring members 70 is attached in a substantially horizontal posture on the upper surface of the battery block 10B by laser welding. Thus, the size in a height direction required to attach the wiring members 70 can be made smaller than that when the wiring members 70 are attached on the upper surface of the battery block 10B with a screw. Therefore, the size in the height direction of the battery module 100 can be reduced because not only the voltage/current bus bar 40y but also the wiring members 70 can be attached without occupying a large space.

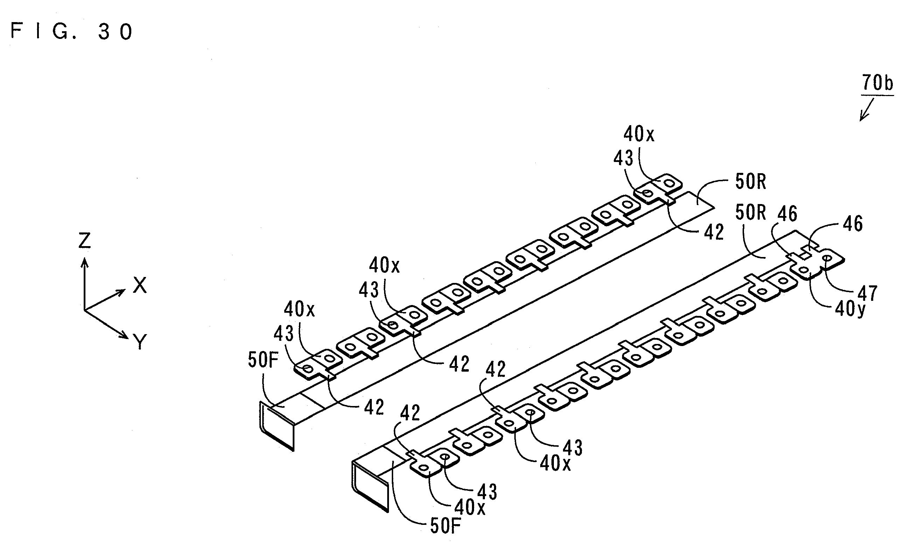

Fig. 30 is an external perspective view illustrating another example of wiring members. Wiring members 70b illustrated in Fig. 30 differ from the wiring members 70 illustrated in Fig. 29 in the following points.

As illustrated in Fig. 30, the wiring members 70b in the present embodiment include two FPC boards 50F and two rigid boards 50R instead of the two FPC boards 50 illustrated in Fig. 29. The rigid boards 50R are long-sized rigid printed circuit boards extending in an alignment direction (X-direction) of a plurality of battery cells 10 (Fig. 2).

Attachment portions 42 in a plurality of voltage bus bars 40x are attached at a predetermined spacing along the alignment direction (X-direction) of the plurality of battery cells 10 to one of the rigid boards 50R. One of the FPC boards 50F is arranged to extend in the alignment direction (X-direction) of the plurality of battery cells 10 from one end of the one rigid board 50R. The FPC board 50F is folded downward at an upper end portion of one of end surface frames 92 (Fig. 2), and is connected to a printed circuit board 21.

Attachment portions 42 in a plurality of voltage bus bars 40x and attachment portions 46 in a voltage/current bus bar 40y are attached at a predetermined spacing along the alignment direction (X-direction) of the plurality of battery cells 10 to the other rigid board 50R. The other FPC board 50F is arranged to extend in the alignment direction (X-direction) of the plurality of battery cells 10 from one end of the other rigid board 50R. The FPC board 50F is folded downward at an upper end portion of one of the end surface frames 92 (Fig. 2), and is connected to the printed circuit board 21.

Thus, the plurality of voltage bus bars 40x and the voltage/current bus bar 40y are connected to a detection circuit 20 via conductor lines 52 (Fig. 11) provided in the rigid boards 50R and the FPC boards 50F. Since the rigid boards 50R in the wiring members 70 have rigidity, the wiring members 70 become easy to handle and attach to a battery block 10B. Since the FPC boards 50F in the wiring members 70 have flexibility, the wiring members 70 can be folded and connected to the printed circuit board 21.

(6) The movable body such as the electric automobile 600 or the ship according to the above-mentioned embodiment is electrical equipment including the battery module 100 (the battery system 500) while including the motor 602 as a load. The electrical equipment according to the present invention is not limited to the movable body such as the electric automobile 600 and the ship, and may be a cleaning machine, a refrigerator, or an air conditioner. For example, the cleaning machine is electrical equipment including a motor as a load, and the refrigerator or the air conditioner is electrical equipment including a compressor as a load.

### (7) Reference Form

In the above-mentioned embodiment, a part of the bus bar attached to the minus electrode 10b of the battery cell 10 at the one end or the bus bar attached to the plus electrode 10a of the battery cell 10 at the other end is used as the shunt resistor RS.

As a reference form, instead of the shunt resistor RS in the above-mentioned embodiments, a part of a bus bar attached between two battery cells 10, for example, is used as a shunt resistor RS. In this case, instead of one of the plurality of voltage bus bars 40x illustrated in Fig. 5, the voltage/current bus bar 40z illustrated in Fig. 16 is attached between the two battery cells 10. Thus, a part of the bus bar attached between the two battery cells 10 can be used as the shunt resistor RS.

### [5] Correspondences between Constituent Elements in the Claims and Parts in Embodiments

In the following paragraph, non-limiting examples of correspondences between various elements recited in the claims below and those described above with respect to various embodiments of the present invention are explained.

In the embodiments, described above, the battery cell 10 is an example of a battery cell, the battery block 10B is an example of a battery block, the 18th battery cell 10 is an example of a battery cell at one end, and the first battery cell 10 is an example of a battery cell at the other end. The minus electrode 10b of the 18th battery cell 10 is an example of one electrode of the battery cell at one end, the plus electrode 10a of the first battery cell 10 is an example of one electrode of the battery cell at the other end, the shunt resistor RS is an example of a shunt resistor, and the battery module 100 is an example of a battery module.

The screw S is an example of first and second output terminals, the plus electrode 10a is an example of an electrode and a second electrode, and the minus electrode 10b is an electrode and a first electrode. The voltage bus bar 40x is an example of first and third connection members, the voltage/current bus bar 40y is an example of a second connection member and a metal plate, and the voltage/current bus bar 40z is an example of a third connection member.

Copper is an example of first, third, fifth, and sixth metals, aluminum is an example of second, fourth, and seventh metals, the region 41b is an example of a first portion, and the region 41a is an example of a second portion. The detection circuit 20 is an example of a voltage detector, the conductors 51 and 52 are examples of first and second conductor patterns, the FPC board 50 is an example of a wiring substrate, and the attachment portion 46 is an example of first and second regions.

The battery ECU 101 is an example of a current calculator, the battery system 500 is an example of a battery system, the motor 602 is an example of a motor or a power source, the drive wheel 603 is an example of drive wheel, and the electric automobile 600 is an example of an electric vehicle. The vehicle body 610, the ship, the airframe, or the body is an example of a movable body, and the electric automobile 600, the ship, the airplane, or the walking robot is an example of a movable body.

The controller 712 is an example of a controller, the power storage device 710 is an example of a power storage device, the power supply device 700 is an example of a power supply device, and the power conversion device 720 is an example of a power conversion device. The motor 602 or the compressor is an example of a load, the electric automobile 600, the ship, the airplane, the walking robot, the cleaning machine, the refrigerator, or the air conditioner is an example of electrical equipment.

As each of various elements recited in the claims, various other elements having configurations or functions described in the claims can also be used.

### [Industrial Applicability]

The present invention is applicable to various movable bodies, mobile equipment, or the like having electric power as a driving source.

## Claims

1. A battery module comprising:
a battery block including a plurality of battery cells; and
a shunt resistor for current detection attached to one of electrodes of the battery cell at one end of said battery block.

2. The battery module according to claim 1, wherein
said battery block has a first output terminal that outputs electric power from said plurality of battery cells; and
said shunt resistor is connected between the one electrode of the battery cell at said one end and the first output terminal.

3. The battery module according to claim 2, further comprising
a first connection member that connects the respective electrodes of said plurality of battery cells to one another, and
a second connection member that connects the one electrode of the battery cell at said one end and said first output terminal to each other,
wherein at least a part of said second connection member is used as said shunt resistor.

4. The battery module according to claim 3, wherein said battery block further has a second output terminal that outputs electric power from each of said plurality of battery cells, further comprising
a third connection member that connects one of the electrodes of the battery cell at the other end of said battery block and the second output terminal to each other.

5. The battery module according to claim 4, wherein
each of the battery cells includes
a first electrode formed of a first metal material, and
a second electrode formed of a second metal material,
said first connection member includes
a first portion formed of a third metal material, and
a second portion formed of a fourth metal material,
said first portion in said first connection member is connected to said first electrode of the one battery cell,
said second portion in said first connection member is connected to said second electrode of the other battery cell,
one of the electrodes of the battery cell at said one end is said first electrode,
one of the electrodes of the battery cell at said other end is said second electrode,
said second connection member is formed of a fifth metal material, and is attached to one of the electrodes of the battery cell at said one end,
said third connection member includes
a first portion formed of a sixth metal material, and
a second portion formed of a seventh metal material, said first portion in said third connection member is connected to said second output terminal, and
said second portion in said third connection member is connected to the one electrode of the battery cell at said other end, and
said first, third, fifth, and sixth metal materials include copper, and said second, fourth, and seventh metal materials include aluminum.

6. The battery module according to claim 3, further comprising a voltage detector that detects a voltage between both ends of said shunt resistor in said second connection member.

7. The battery module according to claim 6, further comprising a wiring substrate having first and second conductor patterns electrically connected to said voltage detector, wherein
said second connection member is a metal plate attached to the one electrode of the battery cell at said one end,
said metal plate includes
a first region corresponding to one end of said shunt resistor, and
a second region corresponding to the other end of said shunt resistor, and
said first and second regions in said metal plate are respectively joined to said first and second conductor patterns of said wiring substrate.

8. The battery module according to claim 7, wherein at least one of said second and third connection members and said first connection member are arranged along one direction, and said wiring substrate is provided to extend along said first and second connection members, or at least one of said second and third connection members and said first connection member.

9. A battery system comprising:
the battery module according to claim 1; and
a current calculator that calculates a current flowing through said shunt resistor in said battery module.

10. An electric vehicle comprising:
the battery module according to claim 1;
a motor that is driven with electric power from said battery module; and
a drive wheel that rotates with a torque generated by said motor.

11. A movable body comprising:
one or a plurality of battery modules each including a plurality of battery cells;
a main movable body; and
a power source that converts electric power from each of said one or plurality of battery modules into power for moving said main movable body,
wherein at least one of said one or plurality of battery modules is the battery module according to claim 1.

12. A power storage device comprising:
one or a plurality of battery modules each including a plurality of battery cells; and
a controller that performs control relating to discharge or charge of said one or plurality of battery modules,
wherein at least one of said one or plurality of battery modules is the battery module according to claim 1.

13. A power supply device connectable to an external object, comprising:
the power storage device according to claim 12; and
a power conversion device that converts electric power between each of said one or plurality of battery modules in said power storage device and said external object,
wherein said controller controls said power conversion device.

14. Electrical equipment comprising:
one or a plurality of battery modules each including a plurality of battery cells; and
a load driven with electric power from each of said one or plurality of battery modules,
wherein at least one of said one or plurality of battery modules is the battery module according to claim 1.
